# EUROPEAN PATENT APPLICATION

(11) **EP 4 205 959 A1**
(43) Date of publication of application: **05.07.2023**
(21) Application number: 21875697.1
(22) Date of filing: 29.09.2021
(51) Int. Cl.: B29L 7/00, B29L 11/00, G02B 1/118, B29C 59/04

(54) **OPTICAL FILM AND METHOD FOR MANUFACTURING OPTICAL FILM**

(30) Priority: 30.09.2020 JP 2020164599
(71) Applicant: Dexerials Corporation, Shimotsuke-shi, Tochigi 323-0194 (JP)
(72) Inventor: MURAMOTO, Yutaka, Shimotsuke-shi, Tochigi 323-0194 (JP)
(74) Representative: Müller-Boré & Partner Patentanwälte PartG mbB
(86) International application number: PCT/JP2021/035871
(87) International publication number: WO 2022/071397

(57) **Abstract**

Visibility of an optical film at the time of handling can be improved, and an antireflection region and a visible region can be easily formed on a surface of the optical film in an identical processing step. An optical film 1 includes a base material 11 having flexibility and a resin layer 12 laminated on at least one of surfaces of the base material 11. The resin layer 12 includes a concave-convex pattern region 2 in which a micro concave-convex structure 20 composed of a plurality of convexities 21 or concavities 22 arrayed at a pitch P less than or equal to a wavelength of visible light are formed and a strip-shaped line marker region 3 in which a plurality of ridge portions 31 arrayed at intervals from one another at a track pitch Pₜ more than or equal to the wavelength of visible light are formed.

## Description

### Technical Field

The present invention relates to an optical film and a method for manufacturing an optical film.

### Background Art

In recent years, the development of an imprinting technology of pressing a roll master having a micro concave-convex structure formed on its outer peripheral surface against a film to transfer the micro concave-convex structure of the roll master to the film has been advanced as one of microfabrication technologies. Using this imprinting technology, a micro concave-convex structure (what is called a moth-eye structure) arrayed in a cycle (pitch) less than or equal to the wavelength of visible light, for example, can be transferred to a surface of a transparent plastic film having flexibility (hereinafter referred to as a "transparent film"). This can provide the transparent film with an antireflection function, so that an optical film having the antireflection function (which hereinafter may also be referred to as an "antireflection film") can be manufactured.

In this case, a film roll of an antireflection film to which the micro concave-convex structure has been transferred can be efficiently mass-produced using an imprinting technology by a roll-to-roll technique through use of a roll master. In detail, in an imprinting process, a surface of an elongated film base material unwound from the roll is coated with a curable resin layer, and the micro concave-convex structure on the outer peripheral surface of the roll master is transferred to the curable resin layer. Thereafter, an antireflection film having the micro concave-convex structure transferred to its surface is manufactured by curing the curable resin layer, and is taken up into a film roll. Then, the elongated antireflection film is delivered from this film roll and cut into individual pieces, thereby obtaining a sheet product of the antireflection film having a predetermined shape. Further, this sheet-shaped antireflection film is cut out into a desired shape or die-cut, thereby manufacturing a shield member such as an eye shield or a face shield, for example.

Patent Literature 1, for example, discloses an eye shield that reflects less light even under an illumination system having a very high intensity used in a surgery or the like and has anti-fogging properties. This eye shield of Patent Literature 1 is made of a transparent film having flexibility, and moth-eye structures having antireflection properties are formed on both surfaces of the transparent film. The transparent film thereby has a light transmittance (a wavelength of 550 nm) more than or equal to 98.5%, so that a transparent eye shield that reflects less light even under an illumination having a high intensity can be provided.

### Citation List

### Patent Literature

Patent Literature 1: JP 2014-155689A

### Summary of Invention

### Technical Problem

However, an antireflection film having a high transmittance as described in Patent Literature 1 above is disadvantageously low in visibility at the time of handling. In other words, when the antireflection film is highly transparent and reflects less light as described above, a user cannot view the transparent antireflection film or finds difficulty in viewing the transparent antireflection film. This causes inconveniences such as a failure in handling a sheet product of the antireflection film well at the time of handling (such as, for example, when carrying or putting on/off the eye shield) and difficulty in finding the antireflection film if it is dropped. Thus, it has conventionally been demanded to partially form a visible region in an antireflection film mostly occupied by a transparent region to improve user handling properties of the antireflection film.

On the other hand, if another step of forming a visible region partially in the antireflection film is added besides the step of transferring the micro concave-convex structure for providing the above-described antireflection function in the process of manufacturing the antireflection film, a problem arises in that productivity of the antireflection film is reduced due to the increased number of steps. Consequently, it has also been demanded to easily enable a visible region to be formed partially in the antireflection film without adding a step other than the transfer step.

The present invention was therefore made in view of the above-described problems, and an object of the present invention is to improve visibility of an optical film at the time of handling and to easily enable an antireflection region and a visible region to be formed on a surface of the optical film in an identical processing step.

### Solution to Problem

In order to solve the above-described problems, according to an aspect of the present invention, there is provided an optical film including:
a base material having flexibility; and
a resin layer laminated on at least one of surfaces of the base material, in which
the resin layer includes
   a concave-convex pattern region in which a micro concave-convex structure composed of a plurality of convexities or concavities arrayed at a pitch less than or equal to a wavelength of visible light is formed, and
   a strip-shaped line marker region in which a plurality of ridge portions arrayed at intervals from one another at a track pitch more than or equal to
   the wavelength of visible light are formed.

Each of the ridge portions may have a linear shape extending in a longitudinal direction of the line marker region, and the plurality of ridge portions may be arrayed in parallel to one another.

Visible light divided per wavelength may be output from the line marker region by diffraction and interference of light incident on the line marker region because of a cyclic structure of the ridge portions arrayed in the line marker region.

The concave-convex pattern region may be a transparent region provided with an antireflection function by the micro concave-convex structure, and the line marker region may be a visible region that functions as a diffraction grating because of a cyclic structure of the ridge portions.

The track pitch of the ridge portions may be more than or equal to 500 nm and less than or equal to 1 mm.

The track pitch of the ridge portions may be more than or equal to 1 µm and less than or equal to 10 µm.

A height of the ridge portions may be substantially identical to a height of the convexities of the micro concave-convex structure.

The ridge portions may be intermittently formed in the line marker region, and identification information including at least any of a character, a symbol, or a marker may be displayed in a visible manner by portions in which the ridge portions are not formed.

The identification information may include a marker representing a reference position of a peripheral direction of a roll master used for manufacturing the optical film.

The identification information may include a character or a symbol representing a lot number when the optical film is manufactured.

The optical film may be a film roll obtained by winding an elongated film.

The optical film may be a sheet product of a film having a predetermined shape.

In addition, in order to solve the above-described problems, according to another aspect of the present invention, there is provided a method for manufacturing the optical film using a roll master, the method including:
preparing the roll master including a master concave-convex pattern region and a master line marker region on an outer peripheral surface of the roll master, a master micro concave-convex structure having a shape obtained by inverting the micro concave-convex structure in the concave-convex pattern region of the optical film being formed in the master concave-convex pattern region, the master line marker region being provided in a strip shape across an entire periphery of the roll master, and a spiral groove having a shape obtained by inverting the ridge portions in the line marker region of the optical film being formed in the master line marker region;
coating a surface of the base material of the optical film with a resin layer made of a curable resin; and
transferring a transfer pattern including the master micro concave-convex structure formed in the master concave-convex pattern region of the roll master and the groove formed in the master line marker region to the resin layer of the optical film to integrally form the micro concave-convex structure in the concave-convex pattern region of the optical film and the ridge portions in the line marker region of the optical film in the resin layer.

### Advantageous Effects of Invention

As described above, the present invention can improve visibility of an optical film at the time of handling and easily enables an antireflection region and a visible region to be formed on a surface of the optical film in an identical processing step.

### Brief Description of Drawings

[FIG. 1] FIG. 1 is a perspective view showing a film roll of an optical film according to an embodiment of the present invention.
[FIG. 2] FIG. 2 is a partial magnified cross-sectional view showing the optical film according to the embodiment.
[FIG. 3] FIG. 3 is a partial magnified perspective view showing the optical film according to the embodiment.
[FIG. 4] FIG. 4 is a plan view showing an example of a micro concave-convex structure in the optical film according to the embodiment.
[FIG. 5] FIG. 5 is a perspective view schematically showing a roll master according to the embodiment.
[FIG. 6] FIG. 6 is a block diagram showing a configuration of an exposure device to be used for manufacturing the roll master according to the embodiment.
[FIG. 7] FIG. 7 is a schematic view roughly showing a method for exposing the roll master according to the embodiment.
[FIG. 8] FIG. 8 is an explanatory diagram showing a correspondence relationship between an exposure signal and an exposure pattern according to the embodiment.
[FIG. 9] FIG. 9 is a process diagram showing a method for manufacturing the roll master according to the embodiment.
[FIG. 10] FIG. 10 is a process diagram showing the method for manufacturing the roll master according to the embodiment.
[FIG. 11] FIG. 11 is a process diagram showing a method for manufacturing the optical film according to the embodiment.
[FIG. 12] FIG. 12 is a process diagram showing the method for manufacturing the optical film according to the embodiment.
[FIG. 13] FIG. 13 is a schematic view showing a configuration of a transfer device according to the embodiment.
[FIG. 14] FIG. 14 is a plan view showing an example of performing punching processing of a plurality of eye shields from the optical film according to the embodiment.
[FIG. 15] FIG. 15 is an explanatory diagram showing defects in the optical film and the roll master according to the embodiment and a marker.
[FIG. 16] FIG. 16 is a plan view showing a marker and open characters formed in a line marker region of the optical film according to the embodiment.

### Description of Embodiments

Hereinafter, an embodiment(s) of the present invention will be described in detail with reference to the appended drawings. Dimensions, materials, other specific numerical values, and the like indicated in the embodiment(s) are mere exemplifications for facilitating understanding of the invention, and are not intended to limit the present invention unless otherwise specified. Note that, in the present specification and the drawings, elements having substantially the same function and configuration are denoted with the same reference numerals, thereby omitting repeated description, and illustration of elements not directly pertinent to the present invention is omitted.

### [1. Configuration of Optical Film]

### [1.1. General Configuration of Optical Film]

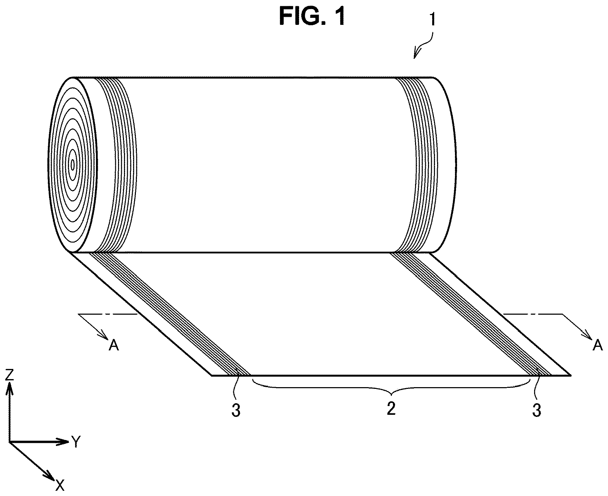

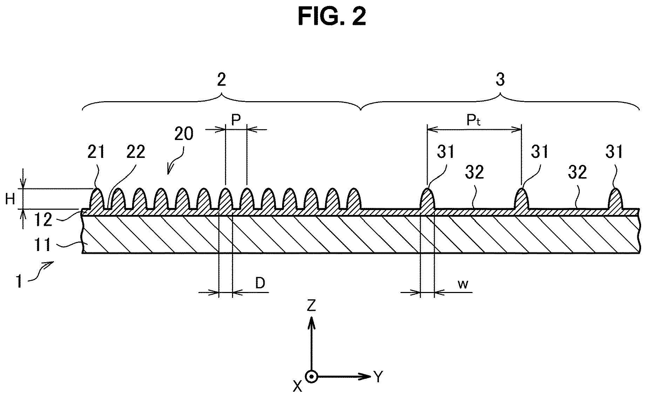

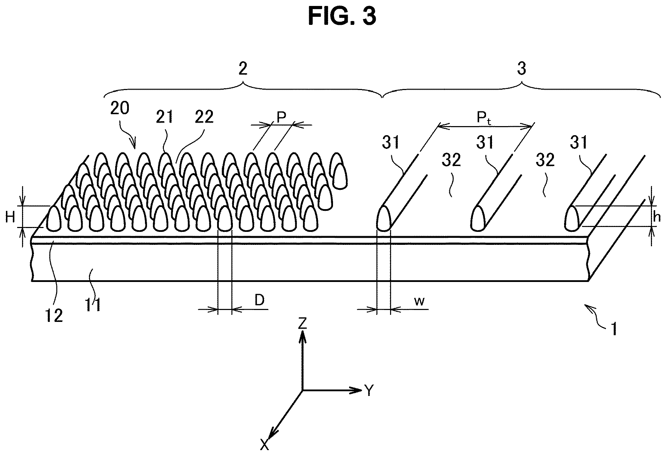

First, a general configuration of an optical film 1 according to an embodiment of the present invention will be described with reference to FIG. 1 to FIG. 3. FIG. 1 is a perspective view showing a film roll of the optical film 1 according to the embodiment of the present invention. FIG. 2 is a partial magnified cross-sectional view showing the optical film 1 according to the present embodiment, and shows a partial magnified cross-section taken along a line A-A in FIG. 1. FIG. 3 is a partial magnified perspective view showing the optical film 1 according to the present embodiment.

As shown in FIG. 1 to FIG. 3, the optical film 1 according to the present embodiment is a transparent optical film (an antireflection film) having an antireflection function, and has transparency to visible light. For example, the optical film 1 is a moth-eye film with a micro concave-convex structure 20 having antireflection properties formed on its surface. Note that in the present embodiment, an example in which a structural body such as the micro concave-convex structure 20 is formed on one of surfaces of the optical film 1 will be mainly described, while structural bodies of the micro concave-convex structure 20 may be formed on both surfaces (both the front and rear surfaces) of the optical film 1.

In general, in a case where a cyclic concave-convex structure is provided on a surface of a transparent film, diffraction occurs when light is transmitted through the concave-convex structure, and a straight-advancing component of transmitted light significantly decreases. However, in a case where the concave-convex structure has a pitch shorter than the wavelength of transmitted visible light, diffraction does not occur, and an antireflection effect which is effective against light having a wavelength corresponding to the pitch, depth, and the like of the concave-convex structure can be obtained. The foregoing micro concave-convex structure 20 having the pitch less than or equal to the wavelength of visible light is also called a moth-eye structure.

By forming the micro concave-convex structure 20 on the surface of the optical film 1, reflection at an interface between the optical film 1 and air can be effectively prevented. For example, in a case of using the optical film 1 for an eye shield or a face shield, it is requested to prevent reflection of external light and keep the field of view of a user well. From this perspective, a refractive index n of the optical film 1 preferably is more than or equal to 1.40 and less than or equal to 2.00, and more preferably is more than or equal to 1.43 and less than or equal to 2.00. In addition, in the optical film 1, transmittance of light having a wavelength of 550 nm preferably is more than or equal to 94.0%, and more preferably is more than or equal to 98.0%, in particular, more than or equal to 98.5%.

The optical film 1 in the example of FIG. 1 is a film roll obtained by winding an elongated film having flexibility into a roll shape. However, the optical film of the present invention is not limited to such an example, and may be a sheet product of a flat film having a predetermined shape (for example, a rectangular shape having predetermined dimensions). The optical film 1 unwound from the film roll is subjected to fashioning processing such as cutting processing or punching processing, thereby obtaining a product (a sheet product) of the optical film 1.

As shown in FIG. 1 to FIG. 3, a surface region of the optical film 1 includes a concave-convex pattern region 2 and a line marker region 3.

The concave-convex pattern region 2 is a transparent region (an antireflection region) provided with the antireflection function by the micro concave-convex structure 20. The micro concave-convex structure 20 composed of a plurality of convexities 21 and concavities 22 arrayed at a pitch P less than or equal to the wavelength of visible light (for example, less than or equal to 350 nm) is formed in the concave-convex pattern region 2. Thus, the concave-convex pattern region 2 of the optical film 1 has a very low reflectance and a high light transmittance. Thus, the user finds difficulty in viewing the transparent concave-convex pattern region 2 of the optical film 1 to the naked eye.

On the other hand, the line marker region 3 is an opaque region (a visible region) which is visible for the user. The micro concave-convex structure 20 as in the above-described concave-convex pattern region 2 is not formed in the line marker region 3, and the antireflection function is not provided. A plurality of ridge portions 31 arrayed in parallel at intervals from one another are formed in the line marker region 3. Each of the ridge portions 31 is a linear convexity extending in a longitudinal direction of the line marker region 3. The plurality of ridge portions 31 are cyclically arrayed at a track pitch Pₜ having a micrometer size (for example, more than or equal to 500 nm and less than or equal to 1 mm) more than or equal to the wavelength of visible light. The line marker region 3 in which the ridge portions 31 having such a cyclic structure are formed functions as a diffraction grating that diffracts visible light.

The cyclic structure of the plurality of ridge portions 31 in the foregoing line marker region 3 causes light incident on the line marker region 3 to diffract and interfere. Thus, light output from the line marker region 3 (transmitted light and reflected light) becomes diffusion light divided per wavelength (per color), and becomes rainbow-colored light which is visible for the user. In this manner, the line marker region 3 is a visible region having the diffraction grating function, and outputs rainbow-colored diffusion light. As a result, the line marker region 3 becomes a visible region that functions as a diffraction grating because of the cyclic structure of the plurality of ridge portions 31.

The concave-convex pattern region 2 occupies most of the region of the surface of the optical film 1. On the other hand, the line marker region 3 is a strip-shaped region extending in a predetermined direction in the optical film 1 (for example, the longitudinal direction of the strip-shaped optical film 1). The line marker region 3 is partially arranged in a partial narrow region of the surface of the optical film 1.

In the example of FIG. 1, the line marker region 3 has a strip shape extending linearly in the longitudinal direction (an X direction) of the elongated optical film 1. In addition, two line marker regions 3, 3 are arranged in the vicinity of both ends in a width direction (a Y direction) of the optical film 1, and each of the line marker regions 3, 3 extends linearly in the longitudinal direction (the X direction) of the optical film 1. The concave-convex pattern region 2 is arranged so as to be sandwiched between these elongated two line marker regions 3, 3. In this manner, in the example of FIG. 1, the wide concave-convex pattern region 2 is arranged at a central part in the width direction (the Y direction) of the optical film 1, and the strip-shaped two line marker regions 3, 3 are arranged at both the sides in the width direction (the Y direction) of the concave-convex pattern region 2.

However, an arrangement pattern of the concave-convex pattern region 2 and the line marker regions 3 is not limited to the example of FIG. 1, and can be modified variously. For example, only a single line marker region 3 may be arranged, or three or more line marker region 3 may be arranged. The line marker regions 3 may have any linear strip shape such as a curved strip shape or a zigzag strip shape, rather than the straight-line strip shape. Alternatively, the line marker regions 3 may have any shape such as a dotted line shape, a broken line shape, a dot shape, an annular shape, a circular shape, an elliptical shape, or a polygonal shape, rather than the strip shape.

However, in order to ensure a wide transparent region of the optical film 1, the concave-convex pattern region 2 preferably has an area larger than the area of the line marker regions 3. It is also preferable that the concave-convex pattern region 2 should be arranged at the central side in the width direction of the optical film 1, and the line marker regions 3 should be arranged at the end sides in the width direction of the optical film 1.

As described above, the optical film 1 according to the present embodiment is a transparent film with line markers. The optical film 1 has the line marker regions 3 extending in a roll peripheral direction as a strip shape adjacently to the concave-convex pattern region 2 in which the micro concave-convex structure 20 arrayed at the pitch P less than or equal to the wavelength of visible light is formed. In other words, the optical film 1 is provided with the line marker regions 3 which are opaque and easily visible in addition to the concave-convex pattern region 2 which is transparent and less visible.

Consequently, the user finds difficulty in viewing light transmitted through the transparent concave-convex pattern region 2, but can easily view rainbow-colored diffusion light output from the line marker regions 3 that function as a diffraction grating. Thus, the user can recognize the presence of the optical film 1 and its position, size, orientation, and the like by viewing the rainbow-colored diffusion light from the line marker regions 3 of the optical film 1. As a result, a transparent product obtained by using the optical film 1, for example, a shield product such as an eye shield or a face shield, is easily visible for the user. This can improve visibility to the naked eye when the product is handled and improve user convenience.

### [1.2. Layer Structure of Optical Film]

Next, a layer structure of the optical film 1 according to the present embodiment will be described in more detail with reference to FIG. 2 and FIG. 3.

As shown in FIG. 2 and FIG. 3, the optical film 1 includes a transparent base material 11 having flexibility and a transparent resin layer 12 laminated on at least one of surfaces of the base material 11. In this manner, the optical film 1 according to the present embodiment has a two-layer structure at least including the base material 11 and the resin layer 12. However, the optical film 1 is not limited to such an example, and may have a multi-layer structure including three or more layers by providing another intermediate layer such as a close contact layer (not shown) for increasing close contactness between the base material 11 and the resin layer 12. Alternatively, the optical film 1 may have a multi-layer structure including three or more layers by providing the resin layers 12, 12 on both the front and rear surfaces of the base material 11. In addition, a covering layer and the like may be added to a surface of the resin layer 12.

The base material 11 is a transparent film base material having flexibility. The base material 11 may be composed of a single sheet-like transparent member, or may be composed of a plurality of sheet-like transparent members bonded to one another. The base material 11 has a thickness selected as appropriate depending on the application of the optical film 1, and preferably is provided with flexibility, rigidity, thickness, and the like depending on the application.

Examples of the material of the base material 11 include a plastic material having transparency, a glass material, or the like. In detail, examples of the plastic material of the base material 11 include methyl methacrylate (co)polymer, polycarbonate, styrene (co)polymer, methyl methacrylate-styrene copolymer, cellulose diacetate, cellulose triacetate, cellulose acetate butylate, polyester, polyamide, polyimide, polyethersulfone, polysulfone, polypropylene, polymethylpentene, polyvinyl chloride, polyvinyl acetal, polyether ketone, polyurethane, glass, and the like. In addition, examples of the glass material of the base material 11 include soda lime glass, lead glass, hard glass, quartz glass, liquid crystallized glass, and the like. However, the material of the base material 11 is not particularly limited to the materials exemplified above.

In the case of using a plastic material as the base material 11, a primer layer (not shown) may further be provided by surface treatment in order to further improve the surface energy, coatability, slidability, flatness, and the like of a surface of the plastic material. Examples of the primer layer include an organoalkoxymetal compound, polyester, acrylic-modified polyester, polyurethane, and the like. In addition, in order to obtain an effect equivalent to the effect when the primer layer is provided, the surface of the base material 11 may be subjected to a corona discharge treatment, a UV radiation treatment, or the like.

The base material 11 may be formed by a method such as stretching the resin described above, or diluting the resin in a solvent, followed by deposition into a film shape and drying, for example. The thickness of the base material 11 preferably is selected as appropriate depending on the application of the optical film 1, and is more than or equal to 10 µm and less than or equal to 500 µm, for example, preferably is more than or equal to 50 µm and less than or equal to 500 µm, and more preferably is approximately more than or equal to 50 µm and less than or equal to 300 µm. When the thickness of the base material 11 is more than or equal to 10 µm, protection performance of the optical film 1 against an incoming subject is improved. On the other hand, when the thickness of the base material 11 is less than or equal to 500 µm, the optical film 1 can be reduced in weight, and can be transformed in a curved manner because of having flexibility. This improves the feeling of wearing when the optical film 1 is used as a shield member such as an eye shield.

The resin layer 12 is a layer made of resin having transparency, and is laminated on the surface of the base material 11. In order to reduce internal reflection of the optical film 1 and improve contrast, the resin layer 12 preferably has a refractive index similar to the refractive index of the base material 11. In addition, the resin layer 12 preferably has transparency equivalent to transparency of the base material 11. A concave-convex pattern of structural objects such as the micro concave-convex structure 20 in the concave-convex pattern region 2 and the plurality of ridge portions 31 in the line marker regions 3 is formed on the resin layer 12. In the present embodiment, the micro concave-convex structure 20 and the plurality of ridge portions 31 are formed on the identical resin layer 12 in an identical step by a similar processing method (transfer processing with a roll master which will be described later).

The resin layer 12 is a layer formed of a curable resin. The resin layer 12 is formed of a cured product of a curable resin composition (a transfer material) such as an energy beam-curable resin composition, for example. In a step of forming the resin layer 12, first, the surface of the above-described base material 11 is coated with an energy beam-curable resin composition as the transfer material, and the concave-convex pattern such as the above-described micro concave-convex structure 20 is transferred to the energy beam-curable resin composition. Thereafter, the curable resin composition is cured by emission of an energy beam. The resin layer 12 to which the concave-convex pattern has been transferred is thereby formed on the surface of the base material 11.

The energy beam-curable resin composition is resin having properties of being cured by emission of an energy beam. Herein, examples of the energy beam may include UV light, electron beams, infrared light, laser beams, visible light beams, ionization radiation (such as X-rays, α-rays, β-rays, or γ-rays), microwaves, radiofrequency waves, or the like. From the perspective of easy handing and the like, it is preferable to use a UV curable resin composition, for example, as the energy beam-curable resin composition.

In addition, the energy beam-curable resin composition may contain a filler, a functional additive, or the like according to necessity. For example, the UV curable resin composition may contain an acrylate or an initiator, and may contain a monofunctional monomer, a bifunctional monomer, a polyfunctional monomer, or the like.

In addition, a cured product of the energy beam-curable resin composition may have hydrophilicity. Thus, the energy beam-curable resin composition preferably contains one or more types of functional groups having hydrophilicity. Examples of such functional groups having hydrophilicity include a hydroxyl group, a carboxyl group, a carbonyl group, and the like.

### [1.3. Configuration of Micro Concave-Convex Structure in Concave-Convex Pattern Region]

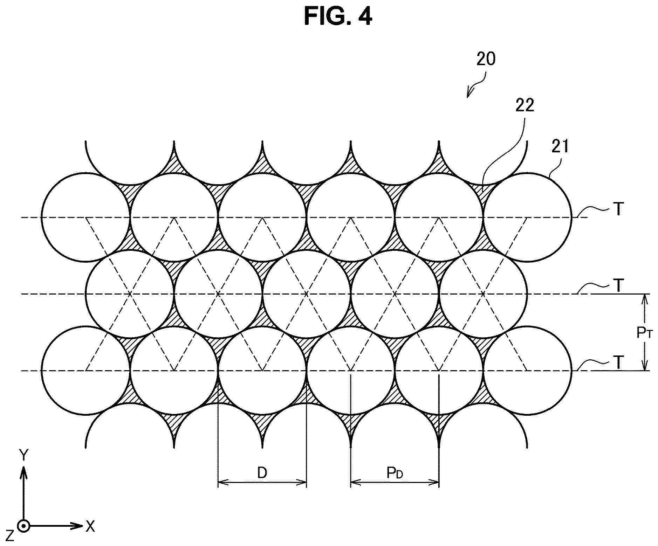

Next, a concave-convex pattern array of the micro concave-convex structure 20 formed in the concave-convex pattern region 2 (the antireflection region) of the optical film 1 according to the present embodiment will be described in more detail with reference to FIG. 2 to FIG. 4. FIG. 4 is a plan view showing an example of the micro concave-convex structure 20 in the optical film 1 according to the present embodiment.

As shown in FIG. 2 to FIG. 4, the micro concave-convex structure 20 (the moth-eye structure) is composed of a plurality of convexities 21 and concavities 22 arrayed at the pitch P less than or equal to the wavelength of visible light. By providing the micro concave-convex structure 20 on the resin layer 12 in the concave-convex pattern region 2 in the entire surface of the optical film 1, a surface (an X-Y plane) of the concave-convex pattern region 2 becomes a concave-convex surface of the moth-eye structure.

The plurality of convexities 21 constituting the micro concave-convex structure 20 protrude in a direction (a Z direction) vertical to the surface of the optical film 1. The concavity 22 is a recessed portion provided between mutually adjacent ones of the plurality of convexities 21, 21.

Examples of a three-dimensional shape of the convexities 21 may include various convex shapes such as a cone shape (such as a bell shape or an elliptical frustum shape), a semispherical shape, semi-elliptical spherical shape, and a pillar shape. Examples of the cone shape include a cone shape with a pointed top, a cone shape having a flat top, and a cone shape having a convex- or concave-curved surface at the top. Examples of the cone shape having a convex-curved surface at the top include a quadric surface shape such as a parabolic shape. In addition, the conical surface of the cone shape may be curved in a concave or convex manner.

In addition, as shown in FIG. 4, the planar shape (dot shape) of the convexities 21 when the convexities 21 are projected on the surface (the X-Y plane) of the optical film 1 is a circular shape, for example, but is not limited to such an example, and may have any shape having a curve, such as an elliptical shape or an oval shape.

Note that the three-dimensional shape and the planar shape of the convexities 21 are not limited to the shapes exemplified above. In addition, the above-described shapes such as a circular shape, an elliptical shape, a spherical shape, a semispherical shape, and a semi-elliptical spherical shape include not only shapes such as a circle, an ellipse, a sphere, a semi-sphere, and a semi-ellipse which are perfect as mathematically defined, but also shapes such as a circle, an ellipse, a sphere, a semi-sphere, and a semi-ellipse which are somewhat distorted. In addition, in the example of FIG. 2 to FIG. 4, the plurality of convexities 21 of the micro concave-convex structure 20 have an identical size, shape, and height H. However, the configuration of the convexities 21 is not limited to this, and the convexities 21 having two or more types of sizes, shapes, and heights may be formed on the surface of the resin layer 12.

The convexities 21 and the concavities 22 of the micro concave-convex structure 20 (which hereinafter may also be referred to as "concavities and convexities of the micro concave-convex structure 20") are cyclically arrayed on the surface (the X-Y plane) of the resin layer 12 at the predetermined pitch P. In this manner, the micro concave-convex structure 20 has a cyclic structure in which the plurality of convexities 21 and concavities 22 are cyclically arrayed on the X-Y plane. Herein, the pitch P refers to a center-to-center distance (a peak-to-peak distance) between mutually adjacent ones of the convexities 21, 21 or a center-to-center distance (a bottom-to-bottom distance) between mutually adjacent ones of the concavities 22, 22, as shown in FIG. 2 and FIG. 3. In this manner, the pitch P of the concavities and convexities of the micro concave-convex structure 20 means the cycle of the cyclic structure of the micro concave-convex structure 20.

Note that the pitch P of the concavities and convexities of the micro concave-convex structure 20 may be an arithmetic mean value (an average pitch, an average cycle) of the center-to-center distance between mutually adjacent ones of the convexities 21, 21 or the concavities 22, 22 of the micro concave-convex structure 20. For example, a plurality of sets of combinations of mutually adjacent ones of the plurality of convexities 21, 21 in the micro concave-convex structure 20 are picked up, the center-to-center distance between the convexities 21, 21 of each of the combinations is measured, and the arithmetic mean value (the average pitch, the average cycle) of these measured values can be calculated as the pitch P. Note that the concave-convex pattern of the micro concave-convex structure 20 can be observed using a microscope such as a scanning-type electron microscope (SEM) or a cross-sectional transmission electron microscope (cross-sectional TEM), for example.

In the present embodiment, in order to provide antireflection properties for visible light, the pitch P of the concavities and convexities of the micro concave-convex structure 20 is less than or equal to the wavelength of visible light. Herein, the wavelength band of visible light is 360 nm to 830 nm, and the concavities and convexities of the micro concave-convex structure 20 according to the present embodiment are regularly arrayed at the pitch P less than the wavelength band of visible light. From such a perspective, the pitch P of the concavities and convexities of the micro concave-convex structure 20 is less than or equal to 350 nm, for example, preferably is less than or equal to 250 nm, and may be approximately 200 nm, for example. In addition, the pitch P of the concavities and convexities of the micro concave-convex structure 20 is more than or equal to 100 nm, for example, preferably is more than or equal to 120 nm, and more preferably is more than or equal to 130 nm. In a case where the pitch P is less than 100 nm, it may be difficult to form the micro concave-convex structure 20, which is not preferable. On the other hand, in a case where the pitch P exceeds 350 nm, diffracted light may be increased in intensity, so that incoming light may be diffracted at the surface on which the micro concave-convex structure 20 is formed and the antireflection effect may be reduced, which is not preferable. If the pitch P is less than or equal to 350 nm, the antireflection properties of the micro concave-convex structure 20 can be improved to obtain a desired antireflection effect.

As shown in FIG. 2 and FIG. 3, the height H of the convexities 21 of the micro concave-convex structure 20 (or the depth of the concavities 22) is not particularly restricted, and is more than or equal to 100 nm and less than or equal to 400 nm, for example, preferably is more than or equal to 150 nm and less than or equal to 300 nm, and more preferably is more than or equal to 200 nm and less than or equal to 300 nm. The height H of the convexities 21 of the micro concave-convex structure 20 may be an arithmetic mean value (an average height) of heights of the plurality of convexities 21 constituting the micro concave-convex structure 20. For example, the heights of the plurality of convexities 21 constituting the micro concave-convex structure 20 are each measured, and the arithmetic mean value (the average height) of these measured values can be calculated as the height H.

An aspect ratio (the height H/the arrangement pitch P) of the convexities 21 of the micro concave-convex structure 20 preferably is more than or equal to 0.66 and less than or equal to 1.96, and more preferably is more than or equal to 0.76 and less than or equal to 1.96. When the aspect ratio is more than or equal to 0.66, low reflection properties can be improved. On the other hand, when the aspect ratio is less than or equal to 1.96, the releasability when separating the micro concave-convex structure 20 from the roll master, and the like can be improved.

A size D of the convexities 21 of the micro concave-convex structure 20 is the size (dot size) of the planar shape of the convexities 21 (or the concavities 22) when the convexities 21 (or the concavities 22) of the micro concave-convex structure 20 are projected on the surface (the X-Y plane) of the optical film 1 as shown in FIG. 4. For example, in a case where the planar shape of the convexities 21 is a circle, the size D of the concavities and convexities is the diameter of the circle, and in a case where the planar shape of the convexities 21 is an ellipse, the size D of the concavities and convexities is the longer diameter of the ellipse.

The size D of the concavities and convexities of the micro concave-convex structure 20 is determined depending on an exposure resolution or the like when exposing the concave-convex pattern of the micro concave-convex structure on the outer peripheral surface of the roll master in a method for manufacturing the roll master which will be described later. The size D of the concavities and convexities of the micro concave-convex structure 20 is less than or equal to the pitch P of the concavities and convexities (for example, less than or equal to 350 nm), preferably is equivalent to the pitch P of the concavities and convexities, and is approximately 200 nm, for example. If the size D of the concavities and convexities is made equivalent to the pitch P as shown in FIG. 4, for example, the plurality of convexities 21 can be densely arranged on the X-Y plane of the micro concave-convex structure 20 to reduce the area of a gap between mutually adjacent ones of the convexities 21, 21. Note that the size D of the concavities and convexities of the micro concave-convex structure 20 may be an arithmetic mean value (an average size) of the sizes of the planar shapes of the plurality of convexities 21 (or the concavities 22) constituting the micro concave-convex structure 20. For example, the sizes of the planar shapes of the plurality of convexities 21 constituting the micro concave-convex structure 20 are each measured, and the arithmetic mean value (the average size) of these measured values can be calculated as the size D.

Herein, an array of the concave-convex pattern of the micro concave-convex structure 20 on the surface (the X-Y plane) of the optical film 1 according to the present embodiment will be described in more detail with reference to FIG. 4. Note that in FIG. 4, the X direction is equivalent to the longitudinal direction of the optical film 1, the Y direction is equivalent to the width direction of the optical film 1, and the Z direction is equivalent to a depth direction of the optical film 1.

As shown in FIG. 4, the plurality of convexities 21 of the micro concave-convex structure 20 are arrayed in a hexagonal lattice shape on the surface of the optical film 1 according to the present embodiment. In the hexagonal lattice array, the plurality of convexities 21 are arranged at positions of vertices of the hexagonal lattice on the X-Y plane. Note that in the example of FIG. 4, the planar shape of the convexities 21 is a circle, but may be another shape such as an ellipse.

Herein, the plurality of convexities 21 are arrayed along a plurality of tracks T parallel to one another. In other words, the plurality of convexities 21 are arrayed along the plurality of rows of tracks T on the surface of the optical film 1.

The tracks T are imaginary straight lines extending in a predetermined first direction on the X-Y plane of the optical film 1, and indicate an array direction of the concave-convex pattern of the micro concave-convex structure 20. The plurality of tracks T are arranged at a predetermined interval (a track pitch P_{T}) in a second direction vertical to the first direction. Herein, the first direction is a direction in which the tracks T extend (hereinafter referred to as a "track extending direction"). The second direction is a direction in which the plurality of tracks T are arrayed (hereinafter referred to as a "track pitch direction") and is the direction vertical to the first direction. As shown in FIG. 4, for example, the first direction (the track extending direction) may be the longitudinal direction (the X direction) of the optical film 1, and the second direction (the track pitch direction) may be the width direction (the Y direction) of the optical film 1, for example. However, the track extending direction is not limited to such an example, and may be any direction other than the longitudinal direction (the X direction) of the optical film 1.

Herein, as shown in FIG. 4, a dot pitch P_{D} is a pitch (cycle) of the plurality of convexities 21 arrayed in the track extending direction (the X direction) along the tracks T. The track pitch P_{T} is a mutual interval between the plurality of tracks T, T adjacent in the track pitch direction (the Y direction).

Similarly to the aforementioned pitch P, the dot pitch P_{D} and the track pitch P_{T} are less than or equal to the wavelength in the visible light band, are less than or equal to 350 nm, for example, preferably are less than or equal to 250 nm, and may be approximately 200 nm, for example. In addition, P_{D} and P_{T} are more than or equal to 100 nm, for example, preferably are more than or equal to 120 nm, and more preferably are more than or equal to 130 nm. This enables the micro concave-convex structure 20 to function as what is called a moth-eye structure that prevents reflection of incident light in a broad wavelength band.

The dot pitch P_{D} and the track pitch P_{T} may be identical or different in size as long as they fall within the above-described ranges. In the example of FIG. 4, the dot pitch P_{D} is larger than the track pitch P_{T} (P_{D} > P_{T}). For example, it can be set such that P_{D} = 230 nm and P_{T} = 150 nm.

In addition, in the hexagonal lattice array of the micro concave-convex structure 20 shown in FIG. 4, the convexities 21 are arranged at positions shifted in the X direction by a half pitch (1/2 P_{D}) between adjacent ones of the tracks T, T in the Y direction. That is, the convexities 21 arrayed in the X direction are shifted by a half cycle (180°) between adjacent ones of the tracks T, T in the Y direction. Specifically, between adjacent two of the tracks T, T, the convexities 21 arrayed on one of the tracks T are arranged at intermediate positions (positions shifted by the half pitch) in the X direction of the convexities 21 arrayed on the other track T. As a result, the plurality of convexities 21 are arranged in a hexagonal lattice pattern on adjacent three rows of the tracks T, as shown in FIG. 4.

In this manner, by shifting the array of the convexities 21 by the half pitch (1/2 P_{D}) for each of the tracks T, the plurality of convexities 21 can be arrayed on the X-Y plane in a hexagonal close-packed lattice shape. Consequently, the proportion of the area occupied by the plurality of convexities 21 (a packing ratio of the convexities 21) on the X-Y plane can be maximized, so that the antireflection function per unit area can be improved.

Note that the array of the concavities and convexities of the micro concave-convex structure 20 is not limited to the above-described example of hexagonal lattice shape, and may have another array form. For example, the array of the concavities and convexities of the micro concave-convex structure 20 may be a square lattice array in which the convexities 21 are arrayed at positions of vertices of square lattices, a rectangular lattice shape, another lattice array, or the like. However, in order to most closely pack the convexities 21 on the X-Y plane, the hexagonal lattice array is preferable.

In addition, the shape of the tracks T is not limited to the example of the linear tracks T as described above, and tracks having a curved shape such as an arc shape may be concentrically arrayed, for example. In addition, the tracks T having these shapes may be wobbled (meander). When the tracks T are wobbled in this manner, non-uniformity in appearance can be prevented from occurring.

### [1.4. Configuration of Ridge Portions in Line Marker Region]

Next, the ridge portions 31 formed in the line marker region 3 (the visible region) of the optical film 1 according to the present embodiment will be described in more detail with reference to FIG. 2 to FIG. 3.

As shown in FIG. 2 and FIG. 3, the plurality of ridge portions 31 are formed in the strip-shaped line marker region 3 on the surface of the resin layer 12 of the optical film 1. The ridge portions 31 are arrayed at intervals from one another at the track pitch Pₜ more than or equal to the wavelength of visible light (for example, more than or equal to 500 nm). The ridge portions 31 according to the present embodiment are linear ridges extending in the longitudinal direction (the X direction) of the strip-shaped line marker region 3. The plurality of linear ridge portions 31 are arrayed in parallel at intervals from one another in the width direction (the Y direction) of the line marker region 3.

In the line marker region 3, a flat portion 32 parallel to the surface of the base material 11 is formed between mutually adjacent ones of the plurality of ridge portions 31. The planar shape of the flat portion 32 is a strip shape extending in the longitudinal direction (the X direction) of the line marker region 3. The ridge portions 31 and the flat portions 32 are alternately arranged in the width direction (the Y direction) of the line marker region 3. Note that the region between mutually adjacent ones of the plurality of ridge portions 31 does not necessarily need to be the flat portion 32, and concavities and convexities such as the (nanometer-size) concave-convex pattern of the above-described micro concave-convex structure 20 may be formed, for example.

The cross-sectional shape (a cross-section in a Y-Z plane) of the ridge portions 31 may be any shape as long as it is a shape protruding in a direction orthogonal to the surface of the base material 11. In the example of FIG. 2 and FIG. 3, the cross-sectional shape of the ridge portions 31 is a bell shape having a convex-curved surface at the top, for example, which is a shape similar to the shape of the convexities 21 of the above-described micro concave-convex structure 20, but is not limited to such an example.

Examples of the cross-sectional shape of the ridge portions 31 may include various convex shapes such as a shape obtained by cutting a cone shape (such as a bell shape or an elliptical frustum shape), a semi-circular shape, a semi-elliptical shape, and a substantially triangular shape. Examples of the cone shape include a cone shape with a pointed top, a cone shape having a flat top, and a cone shape having a convex- or concave-curved surface at the top. Examples of the cone shape having a convex-curved surface at the top include a quadric surface shape such as a parabolic shape. In addition, the conical surface of the cone shape may be curved in a concave or convex manner.

Note that the cross-sectional shape of the ridge portions 31 is not limited to the shapes exemplified above. In addition, the above-described shapes such as a semi-circular shape, a semi-elliptical shape, and a cone include not only shapes such as a semi-circle, a semi-ellipse, and a cone which are perfect as mathematically defined, but also shapes such as a semi-circle, a semi-ellipse, and a cone which are somewhat distorted. In addition, the plurality of ridge portions 31 have an identical size, shape, and height h. However, the configuration of the ridge portions 31 is not limited to this, and the ridge portions 31 having two or more types of sizes, shapes, and heights h may be formed on the surface of the resin layer 12.

The ridge portions 31 are cyclically arrayed at the track pitch Pₜ more than or equal to the wavelength of visible light. Herein, tracks of the ridge portions 31 are imaginary centerlines in the direction in which the individual ridge portions 31 extend. The track pitch Pₜ of the ridge portions 31 is a mutual interval (a center-to-center distance) between mutually adjacent ones of the ridge portions 31, 31. In this manner, the track pitch Pₜ means the cycle of the cyclic structure of the ridge portions 31.

Note that the track pitch Pₜ of the ridge portions 31 may be an arithmetic mean value (an average pitch, an average cycle) of pitches of the plurality of ridge portions 31. For example, a plurality of sets of combinations of mutually adjacent ones of the plurality of ridge portions 31, 31 are picked up, the center-to-center distance between the ridge portions 31, 31 of each of the combinations is measured, and the arithmetic mean value (the average pitch, the average cycle) of these measured values can be calculated as the track pitch Pₜ.

The ridge portions 31 according to the present embodiment are regularly arrayed at the track pitch Pₜ more than or equal to the wavelength band of visible light. The track pitch Pₜ of the ridge portions 31 preferably is more than or equal to 500 nm and less than or equal to 1 mm, more preferably is more than or equal to 1 µm and less than or equal to 10 µm, and may be approximately 1 µm, for example. When the track pitch Pₜ is more than or equal to 500 nm and less than or equal to 1 mm, an arrangement pitch of the plurality of ridge portions 31 falls within an appropriate micron-order range, and thus the plurality of ridge portions 31 suitably function as a diffraction grating. Further, when the track pitch Pₜ is more than or equal to 1 µm and less than or equal to 10 µm, the arrangement pitch of the plurality of ridge portions 31 falls within a more appropriate micron-order range, and thus the plurality of ridge portions 31 more suitably function as the diffraction grating.

A width w of the ridge portion 31 is the width of the ridge portion 31 in the direction (the Y direction) vertical to the direction (the X direction) in which the ridge portion 31 extends. The width w of the ridge portion 31 is not particularly restricted, and may be equivalent to the size D (dot size) of the concavities and convexities of the above-described micro concave-convex structure 20, and may be approximately 200 nm, for example. The width w of the ridge portion 31 may be an arithmetic mean value (an average height) of widths of the plurality of ridge portions 31. For example, the widths of the plurality of ridge portions 31 are respectively measured, and the arithmetic mean value (the average width) of these measured values can be calculated as the width h.

The height h of the ridge portion 31 is a protruding height of the ridge portion 31 from the surface of the resin layer 12 (a reference surface of the flat portions 32). The height h of the ridge portions 31 is not particularly restricted, and is more than or equal to 100 nm and less than or equal to 400 nm, for example, preferably is more than or equal to 150 nm and less than or equal to 300 nm, and more preferably is more than or equal to 200 nm and less than or equal to 300 nm. The height h of the ridge portion 31 may be an arithmetic mean value (an average height) of heights of the plurality of ridge portions 31. For example, the heights of the plurality of ridge portions 31 are each measured, and the arithmetic mean value (the average height) of these measured values can be calculated as the height h.

The height h of the ridge portions 31 preferably is substantially identical to the height H of the convexities 21 of the micro concave-convex structure 20. Herein, the description that the height h and the height H are substantially identical means that one of the heights falls within a range of ±30%, preferably falls within a range of ±10%, and more preferably falls within a range of ±5% of the other height. When the height h and the height H are substantially identical, no difference in height occurs between the ridge portions 31 in the line marker region 3 and the convexities 21 of the micro concave-convex structure 20 in the concave-convex pattern region 2. This brings about an effect that when the optical film 1 is taken up into a film roll shape, rolling distortion is unlikely to occur.

The aspect ratio (the height h/the arrangement pitch Pₜ) of the ridge portions 31 preferably is less than or equal to 1.96. When the aspect ratio of the ridge portions 31 is less than or equal to 1.96, the releasability when separating the ridge portions 31 from the roll master, and the like can be improved.

The configuration of the plurality of ridge portions 31 provided in the line marker region 3 according to the present embodiment has been described above. The cyclic structure of the plurality of ridge portions 31 in the line marker region 3 causes light incident on the line marker region 3 to diffract and interfere, so that visible light (rainbow-colored light) divided per wavelength is output from the line marker region 3.

In detail, the cyclic structure of the plurality of ridge portions 31 in the line marker region 3 functions as the diffraction grating. In general, the diffraction grating refers to linear concavities and convexities provided in parallel in a micrometer-size cycle (pitch). A pattern (one-dimensional cyclic pattern) in which the plurality of linear ridge portions 31 are arrayed in parallel at the micrometer-size track pitch Pₜ in the line marker region 3 according to the present embodiment.

The one-dimensional pattern of the ridge portions 31 in the foregoing line marker region 3 functions as the diffraction grating. In other words, when light in which a plurality of colors (wavelengths) are mixed, such as solar light, fluorescent light, or a LED lamp, is incident on the line marker region 3, the diffraction grating composed of the ridge portions 31 causes the incident light to diffract and interfere. Herein, either transmitted light transmitted through the line marker region 3 or reflected light reflected at the line marker region 3 causes diffraction and interference because of the diffraction grating composed of the ridge portions 31. Such diffraction and interference causes light incident on the line marker region 3 to be divided per color (wavelength), diffused in different directions, and output. As a result, output light from the line marker region 3 becomes rainbow-colored diffusion light which is visible for a user of the optical film 1.

Note that in the present embodiment, the diffraction grating in the one-dimensional cyclic pattern in which the linear ridge portions 31 are aligned in parallel is used, whilst the ridge portions of the present invention are not limited to such an example. For example, a pattern (a two-dimensional cyclic pattern) in which a plurality of ridge portions are arrayed two-dimensionally, such as a pattern in which curved ridge portions are arrayed concentrically, may be used as the diffraction grating.

In more detail, the ridge portions 31 according to the present embodiment are linear and extend in the direction parallel to the longitudinal direction (the X direction) of the line marker region 3. However, the shape of the ridge portions of the present invention is not limited to such an example. As long as the plurality of ridge portions are arranged at the micrometer-size track pitch Pₜ apart from one another, an assembly of the plurality of ridge portions may function as the diffraction grating for visible light. Thus, the extending direction and shape of the ridge portions are not limited to those of the example of the FIG. 2 and FIG. 3 described above. For example, the ridge portions may have a line shape of various forms such as a linear shape, a broken line shape, a dotted line shape, a wavy line shape, and a zigzag shape extending not only in the longitudinal direction (the X direction) of the line marker regions 3, but also in the direction orthogonal to the longitudinal direction and any other direction. For example, the ridge portions may have a broken line shape, dotted line shape, or the like discontinuously interrupted, rather than a continuous linear shape. Alternatively, the ridge portions may have a curved shape such as an arc shape and may be concentrically arranged.

In addition, in the present embodiment, the concave-convex pattern region 2 in which the micro concave-convex structure 20 is formed and the line marker region 3 in which the ridge portions 31 are formed are sectioned on the surface of the optical film 1 without overlapping each other. However, this is not a limitative example, and, for example, the concave-convex pattern region 2 and the line marker region 3 may overlap each other, and the ridge portions 31 may be formed on the micro concave-convex structure 20 in a superimposed manner. Since the ridge portions 31 arrayed at the micrometer-size track pitch Pₜ function as the diffraction grating even in such a superimposed structure, visible rainbow-colored light can be produced.

As described above, in the present embodiment, the line marker region 3 provided with the ridge portions 31 that function as the diffraction grating becomes a visible region that outputs rainbow-colored diffusion light. Thus, the user can recognize the presence of the optical film 1 and its position, size, orientation, and the like by viewing the rainbow-colored diffusion light from the line marker region 3 of the optical film 1. This can improve visibility to the naked eye when handling a product obtained by using the optical film 1 and improve user convenience.

### [2. Configuration of Roll Master]

### [2.1. Overall Configuration of Roll Master]

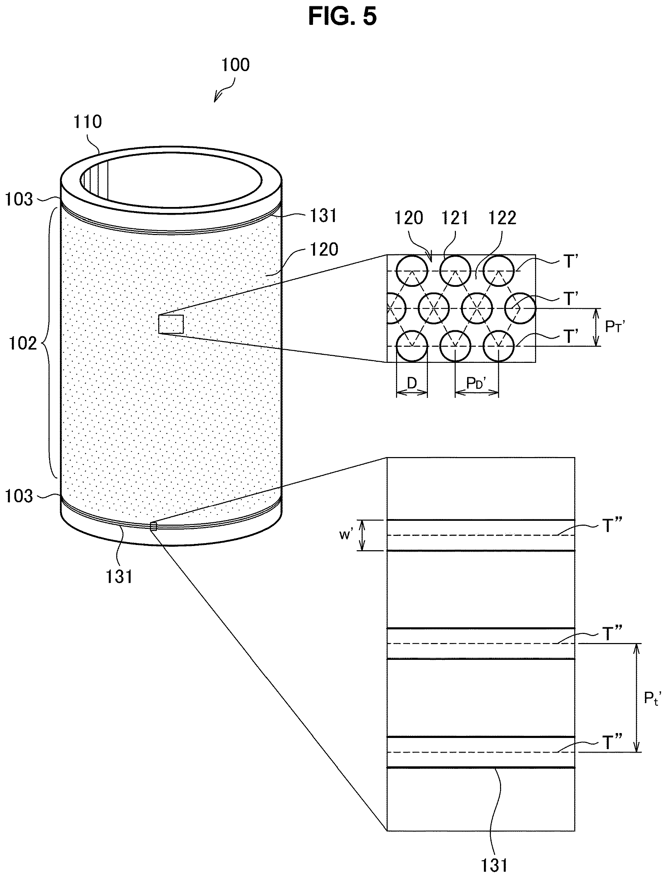

Next, a configuration of a roll master 100 to be used for manufacturing the optical film 1 according to the present embodiment will be described with reference to FIG. 5. FIG. 5 is a perspective view schematically showing the roll master 100 according to the present embodiment.

As shown in FIG. 5, the roll master 100 according to the present embodiment includes a master base material 110, and a concave-convex pattern (a micro concave-convex structure 120 and spiral grooves 131) formed on an outer peripheral surface of the master base material 110.

The roll master 100 according to the present embodiment is a master to be used in the imprinting technology by the roll-to-roll technique, for example. In the imprinting technology by the roll-to-roll technique, by pressing an outer peripheral surface of the roll master 100 against a strip-shaped optical film while rotating the roll master 100, the concave-convex pattern formed on the outer peripheral surface of the roll master 100 can be transferred to the surface of the optical film. Through use of this imprinting technology, a large-area optical film to which the concave-convex pattern formed on the outer peripheral surface of the roll master 100 has been transferred can be efficiently manufactured.

Note that the optical film to which the concave-convex pattern has been transferred by the roll master 100 is used as the optical film 1 applicable to a shield member such as a face shield or an eye shield described above, for example. However, the optical film is not limited to such an example, and may be used for various optical members such as an antireflection film, a surface plasmon filter, or a light-emitting device for another application.

The roll master 100 according to the present embodiment is a roll-shaped master having a cylindrical shape or a columnar shape. The outer peripheral surface of the roll master 100 serves as a fashioning surface for fashioning the concave-convex structure on the surface of the optical film. The concave-convex pattern to be a transfer pattern is two-dimensionally arrayed on the outer peripheral surface of this roll master 100. The concave-convex pattern arranged on the outer peripheral surface of the roll master 100 and the concave-convex pattern arranged on the surface of the aforementioned optical film 1 have an inverted concave-convex relationship. That is, the concave-convex pattern of the roll master 100 are similar to the concave-convex pattern of the optical film 1 in shape, array, arrangement pitch, and the like.

The master base material 110 is a member having a cylindrical shape or a columnar shape as shown in FIG. 5, for example. The concave-convex pattern as a transfer target is formed on the outer peripheral surface of the master base material 110. The master base material 110 may be composed of a glass material such as fused quartz glass or synthetic quartz glass, or may be composed of metal such as stainless steel, a subject obtained by coating an outer peripheral surface of such a metal with SiO₂ or the like, or the like.

However, at least the outer peripheral surface of the master base material 110 preferably is formed of a glass material such as quartz glass. Further, the entire master base material 110 more preferably is formed of a glass material such as quartz glass. This is because when the master base material 110 is formed of a glass material containing SiO₂ as a main material, a micro concave-convex pattern can be easily formed on the outer peripheral surface of the master base material 110 by etching through use of a fluorine compound. Specifically, a concave-convex pattern is formed on a resist layer provided on the outer peripheral surface of the master base material 110 using lithography with laser light. Thereafter, by dry etching the outer peripheral surface of the master base material 110 using the concave-convex pattern on the resist layer as a mask, the concave-convex pattern can be easily formed on the outer peripheral surface of the master base material 110. Note that the master base material 110 formed of a glass material becomes a transparent roll form, for example.

The size of the master base material 110 is not particularly limited, and an axial length (a roll width) of the master base material 110 may be more than or equal to 100 mm, for example, and the outer diameter of the master base material 110 may be more than or equal to 50 mm and less than or equal to 300 mm, for example. In addition, in the case where the master base material 110 has a cylindrical shape, the thickness of the cylinder may be more than or equal to 2 mm and less than or equal to 50 mm, for example.

As shown in FIG. 5, a concave-convex pattern region 102 (equivalent to a "master concave-convex pattern region") and a line marker region 103 (equivalent to a "master line marker region") are provided on the outer peripheral surface of the master base material 110 according to the present embodiment.

The concave-convex pattern region 102 is a cylindrical curved region provided across the entire periphery in the peripheral direction of the roll master 100 (which hereinafter may also be referred to as a "roll peripheral direction"), and occupies most part of the outer peripheral surface of the master base material 110. The line marker region 103 is an annular curved region provided in a strip shape across the entire periphery in the roll peripheral direction. In the example of FIG. 5, the line marker regions 103, 103 are respectively arranged at both ends in the width direction of the roll master 100 (which hereinafter may also be referred to as a "roll width direction"). These line marker regions 103, 103 are arranged adjacently to the concave-convex pattern region 102 at both the sides in the roll width direction of the concave-convex pattern region 102. The line marker regions 103, 103 are arranged at positions on the inner side from both the ends in the roll width direction of the roll master 100 by a predetermined distance.

The width and area of the concave-convex pattern region 102 are significantly larger than the width and area of the line marker regions 103. For example, the width in the roll width direction of the concave-convex pattern region 102 may be approximately several hundred millimeters (for example, 500 mm), and the width in the roll width direction of the line marker regions 103 may be approximately several millimeters (for example, 2 mm).

The concave-convex pattern region 102 and the line marker regions 103 of the roll master 100 as described above respectively correspond to the aforementioned concave-convex pattern region 2 (the antireflection region) and the line marker regions 3 (the visible regions) of the optical film 1.

### [2.2. Configuration of Micro Concave-Convex Structure in Concave-Convex Pattern Region]

Next, the micro concave-convex structure 120 formed in the concave-convex pattern region 102 on the outer peripheral surface of the roll master 100 according to the present embodiment will be described in detail with reference to FIG. 5.

The micro concave-convex structure 120 (equivalent to a "master micro concave-convex structure") is formed as a transfer pattern in the concave-convex pattern region 102 of the roll master 100. The micro concave-convex structure 120 in the concave-convex pattern region 102 of this roll master 100 has a shape obtained by inverting the micro concave-convex structure 20 in the concave-convex pattern region 2 of the optical film 1. In other words, concavities 121 and convexities 122 of the micro concave-convex structure 120 of the roll master 100 respectively have inverted shapes corresponding to the convexities 21 and the concavities 22 of the micro concave-convex structure 20 of the optical film 1.

In the example of the micro concave-convex structure 120 shown in FIG. 5, the plurality of concavities 121 having a circular planar shape are formed in the concave-convex pattern region 102 of the roll master 100. These concavities 121 are arrayed in a hexagonal lattice shape on the outer peripheral surface of the master base material 110. The convexity 122 is a protruding portion provided between mutually adjacent ones of the plurality of concavities 121, 121.

The micro concave-convex structure 120 will be described in more detail. The plurality of concavities 121 of the micro concave-convex structure 120 are arrayed in the hexagonal lattice shape at a pitch P' less than or equal to the wavelength of visible light on the outer peripheral surface of the roll master 100 according to the present embodiment. The pitch P' of the concavities 121 of the micro concave-convex structure 120 is identical to the pitch P of the convexities 21 of the micro concave-convex structure 20 of the aforementioned optical film 1. The pitch P' is less than or equal to the wavelength in the visible light band, is less than or equal to 350 nm, for example, preferably is less than or equal to 250 nm, and may be approximately 200 nm, for example.

Herein, similarly to the hexagonal lattice array of the convexities 21 of the aforementioned micro concave-convex structure 20 (see FIG. 4), the concavities 121 of the micro concave-convex structure 120 of the roll master 100 are also arrayed along a plurality of tracks T' parallel to one another as shown in a magnified view in FIG. 5. The plurality of tracks T' are arranged at a predetermined interval (a track pitch P_{T}') in the second direction (the track pitch direction) vertical to the first direction (the track extending direction). For example, as shown in FIG. 5, the first direction (the track extending direction) may be the roll peripheral direction, and the second direction may be the roll width direction.

Herein, a dot pitch P_{D}' is a pitch (cycle) of the plurality of concavities 121 arrayed in the first direction (for example, the roll peripheral direction) along the tracks T'. The track pitch P_{T}' is a mutual interval between the plurality of tracks T' arranged adjacently to one another in the second direction (for example, the roll width direction). The dot pitch P_{D}' and the track pitch P_{T}' of the concavities 121 of the micro concave-convex structure 120 are respectively identical to the dot pitch P_{D} and the track pitch P_{T} of the convexities 21 of the micro concave-convex structure 20 of the aforementioned optical film 1. For example, the dot pitch P_{D}' may be 230 nm, and the track pitch P_{T}' may be 150 nm.

In the hexagonal lattice array of the micro concave-convex structure 120 shown in FIG. 5, the concavities 121 are arranged at positions shifted by a half pitch (1/2 P_{D}') in the roll peripheral direction between adjacent ones of the tracks T', T' in the roll width direction. That is, the concavities 121 arrayed in the roll peripheral direction are shifted in phase by a half cycle (180°) between adjacent ones of the tracks T', T' in the roll width direction.

By shifting the array of the concavities 121 by a half pitch (1/2 P_{D}') for each of the tracks T' (that is, for each round of the roll) in this manner, the plurality of concavities 121 can be arrayed in a hexagonal close-packed lattice shape on the outer peripheral surface of the roll master 100. Consequently, the proportion of the area occupied by the plurality of concavities 121 of the micro concave-convex structure 120 (the packing ratio of the concavities 121) on the outer peripheral surface can be maximized. The antireflection function per unit area of the optical film 1 to which the micro concave-convex structure 120 has been transferred can thereby be improved.

Note that various dimensions such as a depth H', a size D' (dot size), and the aspect ratio (the depth H'/the arrangement pitch P') of the concavities 121 of the micro concave-convex structure 120 are identical to the height H, the size D (dot size), the aspect ratio (the height H/the arrangement pitch P), and the like of the convexities 21 of the micro concave-convex structure 20 of the aforementioned optical film 1. Consequently, detailed description of these dimensions will be omitted.

The micro concave-convex structure 120 formed in the concave-convex pattern region 102 of the roll master 100 has been described above. By transferring the micro concave-convex structure 120 of this roll master 100 to the optical film 1, the aforementioned micro concave-convex structure 20 (see FIG. 2 to FIG. 4) can be suitably formed in the concave-convex pattern region 2 of the optical film 1.

### [2.3. Configuration of Groove in Line Marker Region]

Next, spiral grooves 131 formed in the line marker regions 103 on the outer peripheral surface of the roll master 100 according to the present embodiment will be described in detail with reference to FIG. 5.

In the line marker regions 103 of the roll master 100, the spiral grooves 131 (spiral elongated recessed portions) are formed across the entire periphery in the roll peripheral direction. This spiral groove 131 is formed continuously or discontinuously so as to make a plurality of rounds (for example, several hundred rounds to several thousand rounds) around the outer peripheral surface of the roll master 100.

Herein, the groove 131 is formed in a spiral shape having a track pitch Pₜ' more than or equal to the wavelength of visible light in the outer peripheral surface of the roll master 100. Herein, a track T" of the groove 131 is an imaginary centerline in a portion of a round in the spiral groove 131 that makes a plurality of rounds around the outer peripheral surface of the roll master 100 as shown in FIG. 5. In addition, the track pitch Pₜ' of the groove 131 is an interval (a center-to-center distance) between mutually adjacent two tracks T", T" in the roll width direction of the spiral groove 131 formed in the outer peripheral surface of the roll master 100. In this manner, the track pitch Pₜ' means the cycle of the cyclic structure of the spiral groove 131 formed in the outer peripheral surface of the roll master 100. Note that, as to the track pitch Pₜ' of the groove 131, a plurality of combinations of the mutually adjacent two tracks T", T" in the roll width direction in the groove 131 are picked up, the interval (the center-to-center distance) of each of the combinations is measured, and the arithmetic mean value (the average pitch, the average cycle) of these measured values may be calculated as the track pitch Pt'.

The track pitch Pₜ' of the spiral groove 131 is identical to the track pitch Pₜ of the ridge portions 31 of the aforementioned optical film 1, and is set at a micrometer-size proper value. For example, the track pitch Pₜ' preferably is more than or equal to 500 nm and less than or equal to 1 mm, more preferably is more than or equal to 1 µm and less than or equal to 10 µm, and may be approximately 1 µm, for example. Since the track pitch Pₜ' thereby falls within an appropriate micron-order range, the ridge portions 31 of the optical film 1 formed by transferring the groove 131 of the roll master 100 suitably function as the diffraction grating.

The groove 131 of this line marker region 103 has a shape obtained by inverting the ridge portion 31 in the line marker region 3 of the aforementioned optical film 1. In other words, the cross-sectional shape of the groove 131 has a shape obtained by inverting the cross-sectional shape of the ridge portion 31. Examples of the cross-sectional shape of the groove 131 may include various convex shapes such as a shape obtained by cutting a cone shape (such as a bell shape or an elliptical frustum shape), a semi-circular shape, a semi-elliptical shape, and a substantially triangular shape. Examples of the cone shape include a cone shape with a pointed top, a cone shape having a flat top, and a cone shape having a convex- or concave-curved surface at the top. Examples of the cone shape having a convex-curved surface at the top include a quadric surface shape such as a parabolic shape. In addition, the conical surface of the cone shape may be curved in a concave or convex manner.

A width w' of the groove 131 is identical to the width w of the ridge portion 31. For example, the width w' of the groove 131 may be equivalent to the size D' (dot size) of the concavity 121 of the aforementioned micro concave-convex structure 120, and may be approximately 200 nm.

In addition, a depth h' of the groove 131 is identical to the height h of the ridge portion 31. For example, the depth h' of the groove 131 may be equivalent to the depth H' of the concavity 121 of the aforementioned micro concave-convex structure 120, is more than or equal to 100 nm and less than or equal to 400 nm, for example, preferably is more than or equal to 150 nm and less than or equal to 300 nm, and more preferably is more than or equal to 200 nm and less than or equal to 300 nm.

The spiral groove 131 formed in the line marker region 103 of the roll master 100 has been described above. By transferring the spiral groove 131 of this roll master 100 to the optical film 1, the aforementioned plurality of ridge portions 31 (see FIG. 2 and FIG. 3) can be suitably formed in the line marker region 3 of the optical film 1. As a result, the ridge portions 31 function as the diffraction grating so that rainbow-colored light is diffused from the line marker region 3. Thus, the line marker region 3 becomes a visible region, and handling properties of the optical film 1 are improved.

### [3. Configuration of Exposure Device]

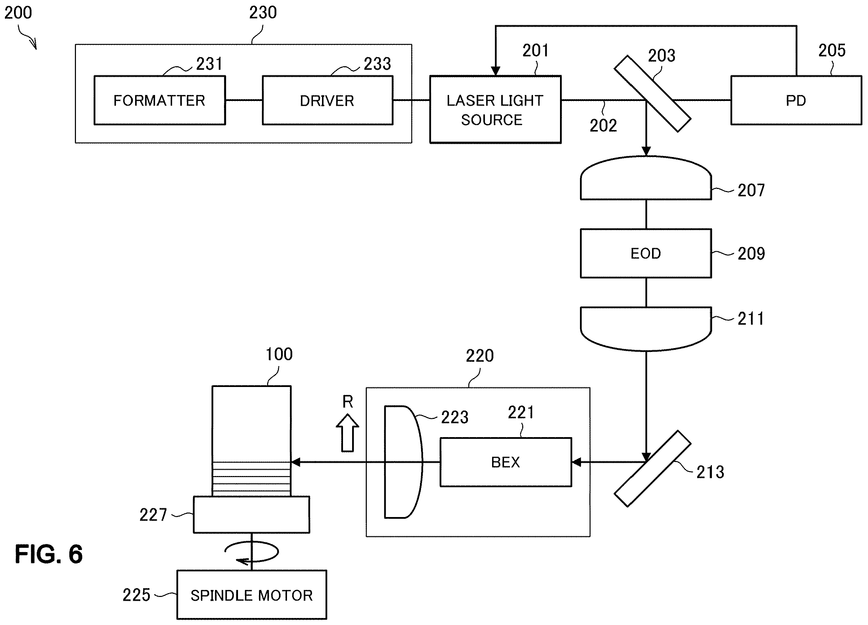

Next, a configuration of an exposure device 200 to be used for manufacturing the roll master 100 according to the present embodiment will be described with reference to FIG. 6. FIG. 6 is a block diagram showing the configuration of the exposure device 200 to be used for manufacturing the roll master 100 according to the present embodiment.

As shown in FIG. 6, the exposure device 200 includes a laser light source 201, a first mirror 203, a photodiode (PD) 205, a condenser lens 207, an electro optic deflector (EOD) 209, a collimator lens 211, a second mirror 213, a movable optical table 220, a spindle motor 225, a turn table 227, and a control device 230.

The laser light source 201 is a light source that outputs laser light 202 for exposing the roll master 100. The laser light source 201 may be a semiconductor laser light source that emits laser light having a wavelength in a blue light band of 400 nm to 500 nm, for example. The laser light source 201 is controlled by the control device 230.

The laser light 202 output from the laser light source 201 straightly advances as a parallel beam, and is reflected at the first mirror 203. The first mirror 203 is composed of a polarizing beam splitter, and has a function of reflecting one of polarization components and transmitting the other polarization component. The polarization component transmitted through the first mirror 203 is photoelectrically converted by the photodiode 205. A photoelectrically converted light reception signal is input to the laser light source 201. The laser light source 201 can thereby adjust output of the laser light 202 based on feedback given by the light reception signal as input.

The laser light 202 reflected at the first mirror 203 is guided to a deflection optical system. The deflection optical system includes the condenser lens 207, the electro optic deflector 209, and the collimator lens 211.

In the deflection optical system, the laser light 202 is condensed by the condenser lens 207 into the electro optic deflector 209. The electro optic deflector 209 is an element capable of controlling an emission position of the laser light 202 at a distance on the order of nanometers. The emission position of the laser light 202 on the master base material 11 can be finely adjusted by the electro optic deflector 209. After the emission position is adjusted by the electro optic deflector 209, the laser light 202 is turned into a parallel beam again by the collimator lens 211. The laser light 202 turned into the parallel beam is reflected by the second mirror 213 and horizontally guided onto the movable optical table 220.

The movable optical table 220 includes a beam expander (BEX) 221 and an objective lens 223. In addition, the roll master 100 is placed on the turn table 227. The turn table 227 is a table that supports the roll master 100 and can be rotated by the spindle motor 225.

The beam expander 221 shapes the laser light 202 guided by the second mirror 213 into a desired beam shape. The shaped laser light 202 is emitted to the resist layer deposited on the outer peripheral surface of the master base material 110 of the roll master 100 via the objective lens 223.

When emitting the laser light 202 to the master base material 110 of the roll master 100, the movable optical table 220 moves the emission position of the laser light 202 in an axial direction of the roll master 100 (the roll width direction) while the turn table 227 and the master base material 110 are being rotated by the spindle motor 225. For example, the movable optical table 220 moves the emission position of the laser light 202 in a direction of an arrow R (a feed pitch direction) by a feed pitch (a track pitch) each time the master base material 110 makes a rotation. This enables the laser light 202 to be spirally emitted to the outer peripheral surface of the master base material 110 to expose the resist layer on the outer peripheral surface of the master base material 110 along a spiral scanning trajectory. Note that the emission position of the laser light 202 may be moved by moving either a laser head including the laser light source 201 or the turn table 227 that supports the roll master 100 along a slider.

In addition, the control device 230 controls output of the laser light 202 from the laser light source 201, thereby controlling an emission time period and the emission position of the laser light 202. The control device 230 generates an exposure signal that controls output of the laser light 202. The control device 230 may have a function generator having a signal generation circuit capable of generating a signal having any waveform, or the like, for example. The control device 230 includes a formatter 231 and a driver 233.

The formatter 231 generates the exposure signal for controlling emission of the laser light 202 from a reference clock signal. The exposure signal is a signal representing the concave-convex pattern to be formed on the outer peripheral surface of the roll master 100. The driver 233 controls emission of the laser light 202 from the laser light source 201 based on the exposure signal generated by the formatter 231. For example, the driver 233 may control the laser light source 201 such that the laser light 202 is emitted in a case where the exposure signal composed of rectangular pulse waves is at a high level. In addition, the spindle motor 225 rotates the turn table 227 based on a rotation control signal generated from the above-described reference clock signal. For example, the spindle motor 225 may control rotation of the turn table 227 such that the turn table 227 makes a rotation during a period in which a predetermined number of pulses of the rotation control signal is input.

As described above, the laser light source 201 is controlled by the exposure signal generated by the control device 230, and the laser light 202 output from the laser light source 201 is emitted to the roll master 100 placed on the turn table 227. In addition, the spindle motor 225 rotates the turn table 227 on which the roll master 100 is placed based on the rotation control signal. Herein, the exposure signal and the rotation control signal are generated from the common reference clock signal, and may be synchronized with each other.

A configuration example of the exposure device 200 according to the present embodiment has been described above. The exposure device 200 according to the present embodiment can expose the outer peripheral surface of the master base material 110 of the roll master 100 to precisely form an exposure pattern (a concave-convex pattern) having a desired shape.

### [4. Exposure Method]

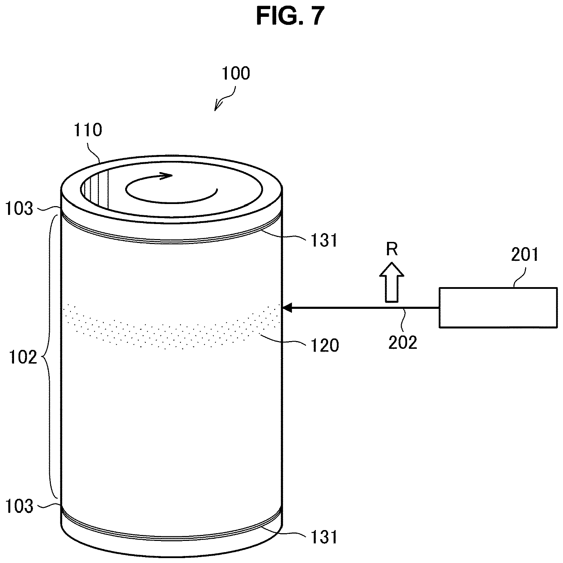

Next, an exposure method for exposing the outer peripheral surface of the master base material 110 of the roll master 100 using the above-described exposure device 200 will be described with reference to FIG. 7. FIG. 7 is a schematic view roughly showing the method for exposing the roll master 100 according to the present embodiment.

As shown in FIG. 7, in the method for exposing the roll master 100 according to the present embodiment, the laser light 202 is emitted to the outer peripheral surface of the master base material 110 using the aforementioned exposure device 200 to form an exposure pattern. The exposure device 200 includes the laser light source 201 that radiates the laser light 202, and the control device 230 that controls output of the laser light 202, as described above.

In an exposure step, the laser light 202 is emitted to the outer peripheral surface of the master base material 110 while rotating the master base material 110 of the roll master 100 around a roll axis and moving the laser light source 201 of the exposure device 200 in the roll width direction (the direction of the arrow R in FIG. 7). The laser light 202 is thereby spirally emitted to the outer peripheral surface of the master base material 110, so that an exposure pattern having a desired shape can be formed in a desired region of the outer peripheral surface of the master base material 110.

In the concave-convex pattern region 102 of the outer peripheral surface of the master base material 110, an exposure pattern corresponding to the above-described micro concave-convex structure 120 is formed. On the other hand, in the line marker regions 103, an exposure pattern corresponding to the above-described spiral grooves 131 is formed. The example of FIG. 7 shows a state in which the exposure pattern corresponding to the micro concave-convex structure 120 is formed by emitting the laser light 202 to the concave-convex pattern region 102 along a spiral emission trajectory. Note that the order of forming the exposure patterns of the micro concave-convex structure 120 and the spiral grooves 131 is not particularly limited.

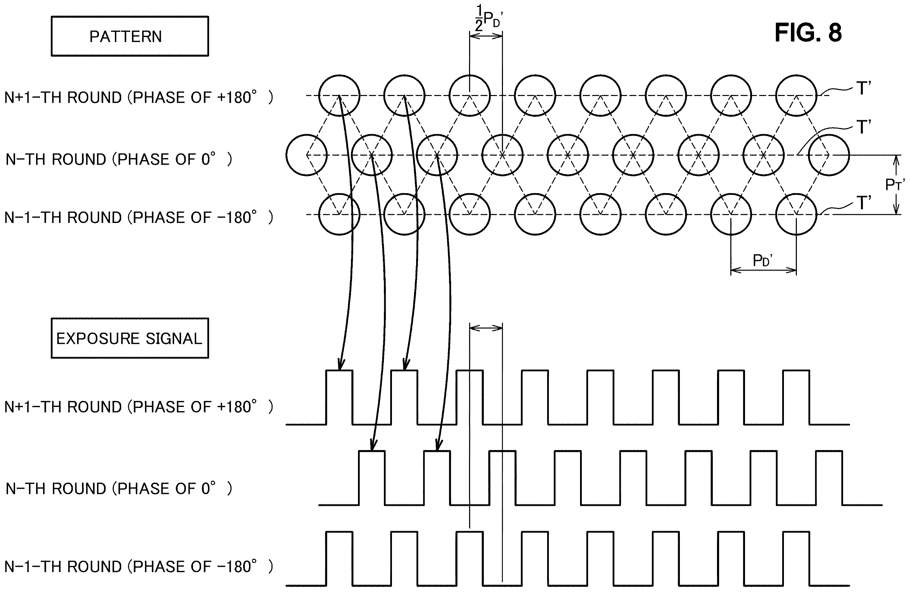

Herein, a correspondence relationship between the exposure signal used by the exposure device 200 according to the present embodiment and the exposure pattern formed on the outer peripheral surface of the master base material 110 will be specifically described with reference to FIG. 8. FIG. 8 is an explanatory diagram showing the correspondence relationship between the exposure signal and the exposure pattern according to the present embodiment.

As shown in FIG. 8, in the present embodiment, an exposure pattern in which circular dot patterns are arrayed in a hexagonal lattice shape is formed on the outer peripheral surface of the master base material 110 by emitting the laser light 202 along the spiral emission trajectory. In this exposure pattern, the circular dot patterns corresponding to the concavities 121 of the micro concave-convex structure 120 are arrayed in the hexagonal lattice shape. These circular dot patterns are arranged along a plurality of rows of tracks T' arrayed at the predetermined track pitch P_{T}'. Note that the planar shape of the dot patterns is not limited to the circular example shown in FIG. 8, and may be an elliptical shape, an oval shape, or the like having a longer axis direction in the direction in which the tracks T' extend, for example.

In order to form the exposure pattern composed of the plurality of dot patterns arrayed along the tracks T', the exposure device 200 according to the present embodiment uses, as the exposure signal, a pulse wave signal that alternately repeats a high level and a low level in a predetermined cycle, for example. The exposure device 200 controls emission of the laser light 202 such that the circular dot patterns are formed on the outer peripheral surface of the master base material 110 when the exposure signal is in the high level.

Further, in order to form the exposure pattern in which the dot patterns are arrayed in the hexagonal lattice shape as shown in FIG. 8, the frequency of the exposure signal is set such that the exposure signal is shifted by a 1/2 pulse between mutually adjacent ones of the tracks T', T' in the roll width direction of the master base material 110. In other words, the exposure signal is inverted in phase by 180° for each round of the spiral laser emission trajectory (that is, for each of the tracks T') while maintaining continuity of the exposure signal. The dot patterns are thereby shifted in position by 0.5 pitch in the roll peripheral direction for each round of the dot patterns spirally arrayed in the roll peripheral direction (that is, for each of the tracks T'). In this manner, the exposure pattern in which the dot patterns are precisely arrayed in a hexagonal lattice shape can be formed on the outer peripheral surface of the master base material 110 using the spiral laser emission trajectory.

In the case of emitting the laser light 202 along the spiral emission trajectory as described above, the length of a round of the outer periphery of the master base material 110 may vary between rounds depending on a processing error of the master base material 110. Thus, in a case where the exposure signal and the rotation control signal are not synchronized with each other, the array of the exposure pattern is disordered with the progress of exposure. In addition, the spindle motor 225 of the turn table 227 that rotates the master base material 110 fluctuates in rotation speed, so that the array of the exposure pattern is disordered due to the fluctuation in rotation speed.

Hence, in the present embodiment, the exposure signal and the rotation control signal are synchronized with each other by sharing a reference clock to be a base of the exposure signal and the rotation control signal. The frequency of the exposure signal can thereby be prevented from being restricted to division or multiplication of the rotation control signal, and can be set at any value. Consequently, a desired exposure pattern can be continuously formed on the outer peripheral surface of the master base material 110 while maintaining continuity of the exposure signal. Thus, in the exposure pattern of the micro concave-convex structure 120 in which the plurality of dot patterns are arrayed in the hexagonal lattice shape, disconnection and array disorder of the exposure pattern can be prevented, and the exposure pattern can be formed with high accuracy and continuously.

The example of forming the exposure pattern having the hexagonal lattice shape corresponding to the micro concave-convex structure 120 in the concave-convex pattern region 102 of the outer peripheral surface of the master base material 110 has been described above with reference to FIG. 8. On the other hand, in the case of forming the exposure pattern corresponding to the spiral grooves 131 in the line marker regions 103, the exposure device 200 emits laser light to the line marker regions 103 along a spiral emission trajectory. At this time, a scanning speed of the laser light 202 (a moving speed of the laser light source 201) in the roll width direction and the rotation speed of the master base material 110 are controlled such that the track pitch Pt' of the spiral groove 131 has a desired dimension. In addition, an emission spot size, an emission intensity, and the like of the laser light 202 are controlled such that the width w' and the depth h' of the spiral groove 131 have desired dimensions.

In this manner, according to the present embodiment, the exposure patterns corresponding to both the micro concave-convex structure 120 in the concave-convex pattern region 102 and the spiral grooves 131 in the line marker regions 103 can be formed on the outer peripheral surface of the roll master 100 using the identical exposure device 200 by similar laser emission methods. Both the exposure patterns can thereby be formed easily and rapidly in the identical exposure step, so that a manufacturing cost and a manufacturing time period of the roll master 100 can be reduced.

### [5. Method for Manufacturing Roll Master]

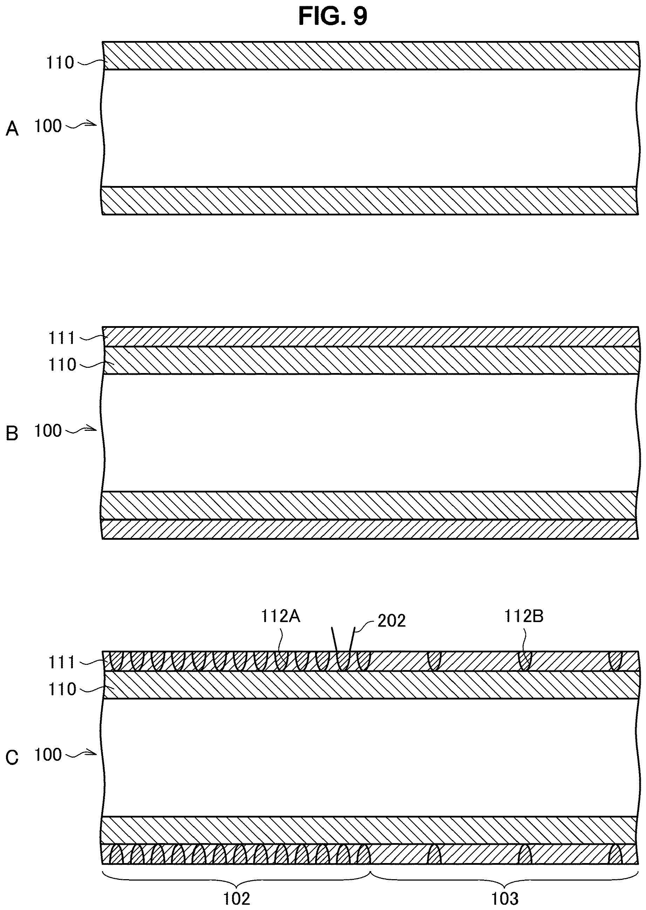

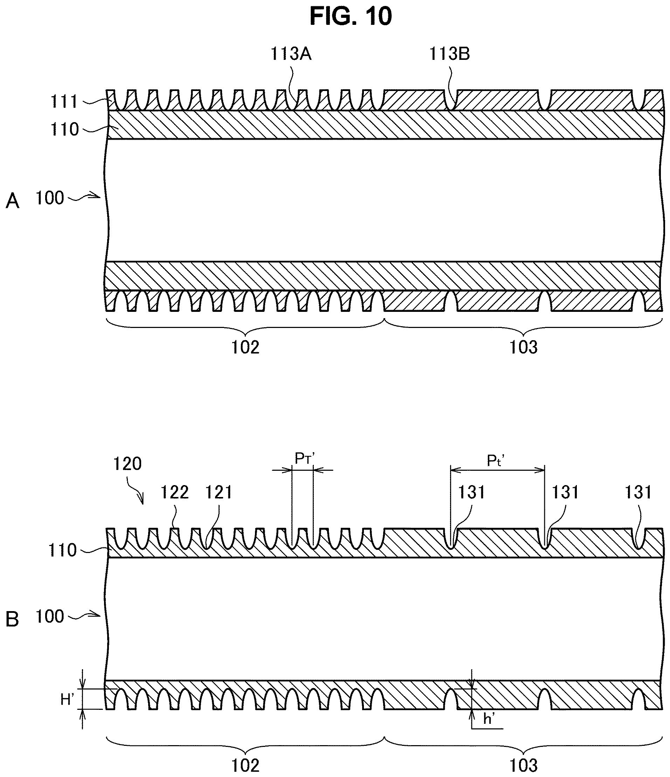

Next, a method for manufacturing the roll master 100 according to the present embodiment will be described with reference to FIG. 9 and FIG. 10. FIG. 9 and FIG. 10 are process diagrams showing the method for manufacturing the roll master 100 according to the present embodiment.

In the present embodiment, the roll master 100 according to the present embodiment is manufactured by forming a concave-convex pattern such as the micro concave-convex structure 120 on the outer peripheral surface of the master base material 110 using lithography with laser light that can control the emission position with high accuracy. Using such lithography with laser light, the array of the concave-convex pattern such as the micro concave-convex structure 120 can be precisely controlled.

The method for manufacturing the roll master 100 according to the present embodiment includes a deposition step (S10), an exposure step (S12), a development step (S14), and an etching step (S16). First, in the deposition step (S10), a resist layer 111 is deposited on the outer peripheral surface of the master base material 110. Then, in the exposure step (S12), laser light is emitted to the resist layer 111 to form a latent image 112. Further, in the development step (S14), the resist layer 111 in which the latent image 112 has been formed is developed to form a pattern in the resist layer 111. Thereafter, in the etching step (S16), etching is performed using the resist layer 111 in which the pattern has been formed as a mask to form concave-convex patterns (such as the micro concave-convex structure 120 and the spiral groove 131) in the outer peripheral surface of the master base material 110. Each step of the method for manufacturing the roll master 100 according to the present embodiment will be described below.

### (S10) Deposition Step

In the deposition step, the master base material 110 of the roll master 100 is prepared first as shown at A in FIG. 9. The master base material 110 is a glass master having a cylindrical shape or a columnar shape, for example. Then, the resist layer 111 is deposited on the outer peripheral surface of the master base material 110 as shown at B in FIG. 9. The resist layer 111 contains an inorganic material or an organic material in which the latent image 112 can be formed with laser light. As the inorganic material, a metal oxide containing one or two or more types of transition metals such as tungsten or molybdenum can be used, for example. In addition, the resist layer containing the inorganic material can be deposited using the sputtering method or the like, for example. On the other hand, as the organic material, a novolac-type resist, a chemically amplified resist, or the like can be used, for example. In addition, the resist layer containing the organic material can be deposited using the spin coating method.

### (S12) Exposure Step

Then, in the exposure step, the laser light 202 is emitted to the resist layer 111 formed on the outer peripheral surface of the master base material 110 as shown at C in FIG. 9. Specifically, the roll master 100 is placed on the turn table 227 of the exposure device 200 shown in FIG. 6. The roll master 100 is rotated, and the laser light 202 (an exposure beam) is emitted to the resist layer 111. At this time, the laser light 202 is emitted to the resist layer 111 while being moved in the axial direction of the roll master 100 (the roll width direction), so that the resist layer 111 is exposed along the spiral emission trajectory. Latent images 112A and 112B (which hereinafter may also be collectively referred to as "latent images 112") in conformity with the emission trajectory of the laser light 202 are thereby formed in the resist layer 111.

In the present embodiment, the laser light 202 is intermittingly emitted along a spiral emission trajectory to the concave-convex pattern region 102 at a central part in the roll width direction of the outer peripheral surface of the roll master 100. The resist layer 111 in the concave-convex pattern region 102 is thereby exposed across the entire surface with the exposure pattern corresponding to the micro concave-convex structure 120 (for example, the pattern in which the circular dot patterns shown in FIG. 8 are arrayed in the hexagonal lattice shape). The latent image 112A of the exposure pattern corresponding to the micro concave-convex structure 120 is formed in the resist layer 111 in the concave-convex pattern region 102.

On the other hand, the laser light 202 is continuously emitted along a spiral emission trajectory to the line marker regions 103 at both the ends in the roll width direction of the outer peripheral surface of the roll master 100. The resist layer 111 in the line marker region 103 is thereby spirally exposed with the exposure pattern corresponding to the spiral groove 131. The latent image 112B of the exposure pattern corresponding to the spiral groove 131 is thereby formed in the resist layer 111 in the line marker region 103. Note that the exposure pattern corresponding to the spiral groove 131 does not necessarily need to have a continuously spiral shape. For example, the laser light 202 may be discontinuously emitted along the spiral emission trajectory to form an exposure pattern having a discontinuous spiral shape.

### (S14) Development Step

Then, in the development step, the resist layer 111 in which the latent image 112 has been formed is developed using a developing solution as shown at A in FIG. 10. A pattern of openings 113A and 113B (which hereinafter may also be collectively referred to as "openings 113") respectively corresponding to the latent images 112A and 112B is thereby formed in the resist layer 111. For example, in the case where the resist layer 111 contains the aforementioned inorganic material, an alkaline solution such as an aqueous solution of TMAH (TetraMethylAmmonium Hydroxide) can be used for development of the resist layer 111. Alternatively, in the case where the resist layer 111 contains the aforementioned organic material, various organic solvents such as ester or alcohol can be used for development of the resist layer 111.

In the development step, the developing solution is dropped onto the resist layer 111 while rotating the roll master 100, for example, to subject the resist layer 111 to development treatment. The plurality of openings 113 are thereby formed in the resist layer 111 as shown at A in FIG. 10. In a case where the resist layer 111 is formed of a positive-type resist, the rate of dissolution with the developing solution at exposed parts exposed with the laser light 202 is higher than at an unexposed part. Thus, the pattern of the openings 113 in conformity with the latent images 112 (the exposed parts) is formed in the resist layer 111.

In the present embodiment, the openings 113A are formed in the concave-convex pattern region 102 in the opening pattern corresponding to the micro concave-convex structure 120 (for example, the pattern in which the circular dot patterns are arrayed in the hexagonal lattice shape shown in FIG. 8). On the other hand, the spiral opening 113B is formed in the line marker region 103 in the opening pattern corresponding to the spiral groove 131.

### (S16) Etching Step

Then, in the etching step, the outer peripheral surface of the master base material 110 is etched using the pattern of the resist layer 111 in which the openings 113 have been formed as a mask. Concave-convex patterns (the micro concave-convex structure 120 and the spiral groove 131) corresponding to the above-described exposure pattern and the pattern of the openings 113 are thereby formed on the outer peripheral surface of the master base material 110 as shown at B in FIG. 10. The master base material 110 may be etched by either dry etching or wet etching. In the case where the master base material 110 is a glass material (such as quartz glass, for example) mainly containing SiO₂, the master base material 110 can be etched by dry etching through use of fluorocarbon gas or wet etching through use of hydrofluoric acid or the like.

The etching step according to the present embodiment allows the micro concave-convex structure 120 corresponding to the openings 113A to be formed as a concave-convex pattern in the concave-convex pattern region 102 of the outer peripheral surface of the master base material 110. The micro concave-convex structure 120 is a moth-eye structure in which a plurality of the concavities 121 and the convexities 122 are arrayed in a hexagonal lattice shape at the pitch P' on the order of nanometers (for example, less than or equal to 350 nm) less than or equal to the wavelength of visible light, for example. On the other hand, the spiral groove 131 corresponding to the openings 113B is formed as a concave-convex pattern in the line marker region 103 of the outer peripheral surface of the master base material 110. The track pitch Pₜ' of the spiral groove 131 in the roll width direction is on the order of micrometers (for example, more than or equal to 500 nm and less than or equal to 1 mm) more than or equal to the wavelength of visible light.

As described above, in the etching step according to the present embodiment, the entire outer peripheral surface of the master base material 110 is etched at the same time using the resist layer 111 in which the opening pattern (the openings 113A and 113B) has been formed as a mask. The micro concave-convex structure 120 (an antireflection concave-convex pattern) in the concave-convex pattern region 102 and the spiral groove 131 (a concave-convex pattern for visibility as a marker) in the line marker region 103 can thereby be processed at the same time in a single etching step on the outer peripheral surface of the master base material 110. Moreover, since the micro concave-convex structure 120 and the spiral groove 131 are formed at the same time under identical etching conditions, the depth h' of the groove 131 is substantially identical to the depth H' of the concavities 121 of the micro concave-convex structure 120.

In contrast, in a case of forming a marker for defect management for a roll master (a sign that represents the position of the roll peripheral direction of the roll master and is formed by a concavity or a convexity that can be transferred to a film) in a surface of the roll master in addition to a micro concave-convex structure, it has conventionally been necessary to separately perform an additional step of processing the marker for defect management after the etching step of forming the micro concave-convex structure. Thus, when separately processing the marker after forming the micro concave-convex structure, there has conventionally been a problem in that there is a risk of causing another defect in the outer peripheral surface of the roll master.

Further, the concavity or convexity of the marker has conventionally been formed by cutting machining or the like other than etching processing, and thus it has been difficult to control the processing accuracy of the concavity or convexity of the marker on the order of nanometers. Consequently, the depth of the concavities of the micro concave-convex structure and the depth of the concavity of the marker are different in the outer peripheral surface of the roll master. Thus, the height of the convexities of the micro concave-convex structure and the height of the convexity of the marker are also different in a film formed by transferring the concave-convex pattern of the roll master, resulting in a difference in height at the film surface. As a result, a problem arises in that when the film is taken up into a film roll, a failure such as rolling distortion occurs.

In this respect, when forming the spiral groove 131 (the concave-convex pattern for visibility as a marker) in the line marker region 103 in the surface of the roll master 100 in addition to the micro concave-convex structure 120 (the antireflection concave-convex pattern) in the concave-convex pattern region 102, the method for manufacturing the roll master 100 according to the present embodiment eliminates the need for an additional step for processing the groove 131 as the marker. In other words, the micro concave-convex structure 120 in the concave-convex pattern region 102 and the spiral groove 131 in the line marker region 103 can be processed at the same time in a single etching step. Thus, according to the present embodiment, the concave-convex pattern of the micro concave-convex structure 120 and the concave-convex pattern of the groove 131 as the marker are processed at the same time, which eliminates the need for adding a step, and brings about an advantage that there is no risk of causing another new defect on the outer peripheral surface of the roll master 100 due to an additional step.

Moreover, the method for manufacturing the roll master 100 according to the present embodiment allows the micro concave-convex structure 120 and the spiral groove 131 to be formed at the same time in a single etching step under identical etching conditions. The depth h' of the groove 131 thereby becomes substantially identical to the depth H' of the concavities 121 of the micro concave-convex structure 120. Consequently, the height H of the convexities 21 of the micro concave-convex structure 20 and the height h of the ridge portions 31 (markers) also become substantially identical in the optical film 1 formed by transferring the concave-convex pattern of the roll master 100, and a difference in height between the convexities does not occur at the surface of the optical film 1. This brings about an advantage that, when the optical film 1 is taken up into a film roll, a failure such as rolling distortion does not occur.

### [6. Method for Manufacturing Optical Film]

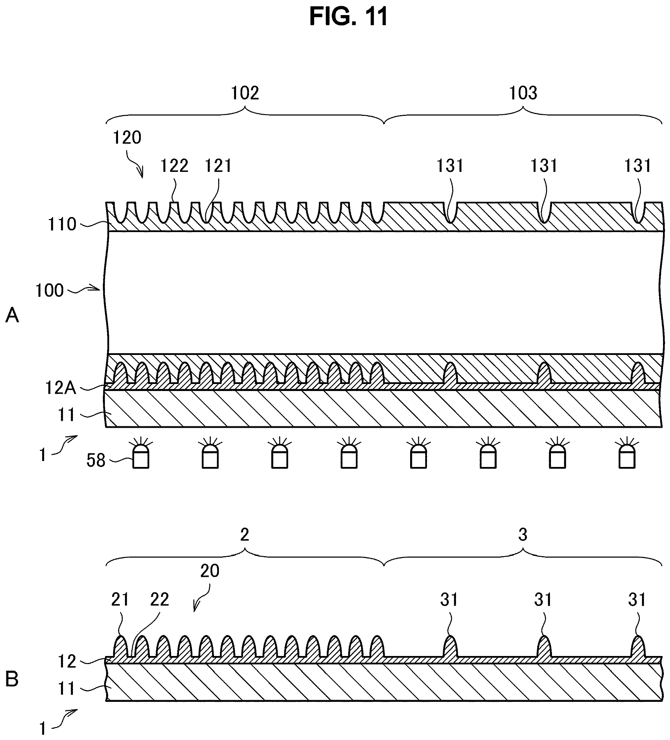

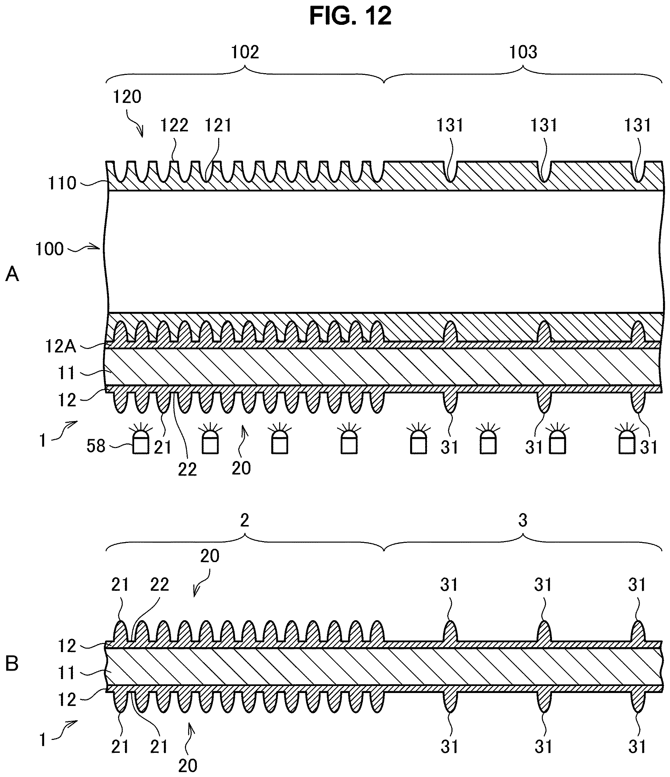

Next, a method for manufacturing the optical film 1 according to the present embodiment will be described with reference to FIG. 11 and FIG. 12. FIG. 11 and FIG. 12 are process diagrams showing the method for manufacturing the optical film 1 according to the present embodiment.

The method for manufacturing the optical film 1 according to the present embodiment includes a step (S20) of preparing the roll master 100, a coating step (S22) of coating the surface of the base material 11 of the optical film 1 with a resin layer 12A made of a curable resin, a first transfer step (S24) of transferring a transfer pattern formed on the outer peripheral surface of the roll master 100 to the resin layer 12A of the optical film 1, and a fashioning step (S28) of fashioning the optical film 1 into a predetermined shape. Further, in a case of providing concave-convex patterns on both surfaces of the optical film 1, the method for manufacturing the optical film 1 according to the present embodiment may include a second coating and transfer step (S26) in addition to the above-described steps.

### (S20) Step of Preparing Roll Master

The step of preparing the roll master 100 may be the respective steps (the deposition step (S10), the exposure step (S12), the development step (S14), and the etching step (S16)) of the method for manufacturing the roll master 100 according to the present embodiment described above with reference to FIG. 9 to FIG. 10, for example. By the method for manufacturing the above-described roll master 100, the roll master 100 having the concave-convex pattern region 102 and the line marker region 103 formed on the outer peripheral surface is suitably prepared.

### Coating Step (S22)

In the coating step, the surface of the base material 11 of the optical film 1 is coated with the resin layer 12A made of a curable resin (a transfer material) and yet to be cured. The curable resin (the transfer material) is a resin material having flowability before being cured, and is an energy-beam curable resin such as, for example, a UV curable resin or a light curable resin. In the present embodiment, the transfer pattern of the roll master 100 is continuously transferred to the resin layer 12A of the optical film 1 by the roll-to-roll technique. Thus, the coating step (S22) and the next transfer step (S24) are executed in parallel at the same time.

### (S24) Transfer Step

In the transfer step (S24), the transfer pattern on the outer peripheral surface of the roll master 100 is transferred to one of the surfaces of the optical film 1. In detail, the resin layer 12A (the transfer material) yet to be cured with which the base material 11 of the optical film 1 has been coated is brought into close contact with the outer peripheral surface of the roll master 100, as shown at A in FIG. 11. Thereafter, an energy beam such as UV rays is emitted from a light source 58 to the resin layer 12A to cure the resin layer 12A. Thereafter, the base material 11 integrated with the resin layer 12A having been cured (equivalent to the resin layer 12) is separated from the roll master 100.

The optical film 1 shown at B in FIG. 11 is thereby obtained. In the optical film 1, the resin layer 12 is laminated on the surface of the base material 11, and the micro concave-convex structure 20 and the ridge portions 31 are formed on the surface of the resin layer 12. Note that an intermediate layer (not shown) such as a close contact layer, an adhesive layer, or a basal layer, for example, may further be provided between the resin layer 12 and the base material 11 of the optical film 1 according to necessity.

The transfer step according to the present embodiment allows the transfer pattern (the micro concave-convex structure 120 and the spiral groove 131) on the outer peripheral surface of the roll master 100 to be transferred to the resin layer 12 of the optical film 1 at the same time, so that the micro concave-convex structure 20 and the plurality of ridge portions 31 are integrally formed on the surface of the resin layer 12 at the same time.

In detail, the micro concave-convex structure 120 in the concave-convex pattern region 102 of the roll master 100 is transferred to the concave-convex pattern region 2 in the resin layer 12 of the optical film 1, so that the micro concave-convex structure 120 having the antireflection function is formed in the concave-convex pattern region 2. The micro concave-convex structure 120 and the micro concave-convex structure 20 have shapes obtained by inverting each other. In addition, the spiral groove 131 in the line marker region 103 of the roll master 100 is transferred to the line marker region 3 of the resin layer 12 of the optical film 1, so that the plurality of ridge portions 31 that function as the diffraction grating are formed in the line marker region 3. The spiral groove 131 and the strip-shaped ridge portions 31 have shapes obtained by inverting each other.

In this manner, the transfer step according to the present embodiment allows the transfer pattern including the micro concave-convex structure 120 formed in the concave-convex pattern region 102 of the roll master 100 and the spiral groove 131 formed in the line marker region 103 to be transferred to the resin layer 12 of the optical film 1 at the same time. In other words, in the optical film 1, the micro concave-convex structure 20 in the concave-convex pattern region 2 and the plurality of ridge portions 31 in the line marker region 3 are integrally formed on the identical resin layer 12. Consequently, two different concave-convex patterns (the micro concave-convex structure 120 and the spiral groove 131) can be efficiently transferred in a single transfer step, which can improve productivity of the optical film 1.

The coating step (S22) and the transfer step (S24) described above allow the concave-convex patterns (the micro concave-convex structure 20 and the ridge portions 31) to be formed on the resin layer 12 on one of the surfaces of the optical film 1, as shown at B in FIG. 11. The resin layer 12 having the concave-convex patterns may be provided only on one of the surfaces of the optical film 1 (on one side) as shown at B in FIG. 11, or may be provided on both surfaces (both the front and rear surfaces) of the optical film 1 as shown at B in next FIG. 12. In the latter case, the second coating and transfer step (S26) to be described next should be executed.

### (S26) Second Application and Transfer Step

In the second coating and transfer step (S26), the other surface (the rear surface) of the base material 11 of the optical film 1 is also coated with the resin layer 12A made of a curable resin after the above-described first transfer step (S24), as shown at A in FIG. 12. Then, a transfer pattern formed on the outer peripheral surface of the roll master 100 is transferred to the resin layer 12A on the other surface (the rear surface) of the optical film 1.

In detail, the resin layer 12A yet to be cured with which the other surface of the base material 11 of the film has been coated is brought into close contact with the outer peripheral surface of the roll master 100, as shown at A in FIG. 12. Then, an energy beam such as UV rays is emitted from the light source 58 to the resin layer 12A to cure the resin layer 12A. Thereafter, the base material 11 integrated with the resin layer 12A having been cured (equivalent to the resin layer 12) is separated from the roll master 100. The resin layers 12 are thereby laminated on both the front and rear surfaces of the base material 11, so that the optical film 1 having the micro concave-convex structures 20 and the ridge portions 31 formed on the surfaces of the resin layer 12 is obtained, as shown at B in FIG. 12.

### (S28) Fashioning Step

Then, in the fashioning step, the optical film 1 obtained in the above-described transfer step (S24 or S26) is fashioned into a predetermined size and shape. For example, the optical film 1 is subjected to processing such as cutting processing into a predetermined size, cutout into a desired shape, or punching processing into a desired shape using a die, thereby fashioning a product (sheet product) of a shield member such as a face shield or an eye shield, or another optical member, for example. A cutting machine, a laser processing device, a punching press device, or the like can be used for such fashioning processing. The use of punching press processing enables processing of forming cut lines necessary for a shield member and cutting processing to be performed in a single step, which is suitable.

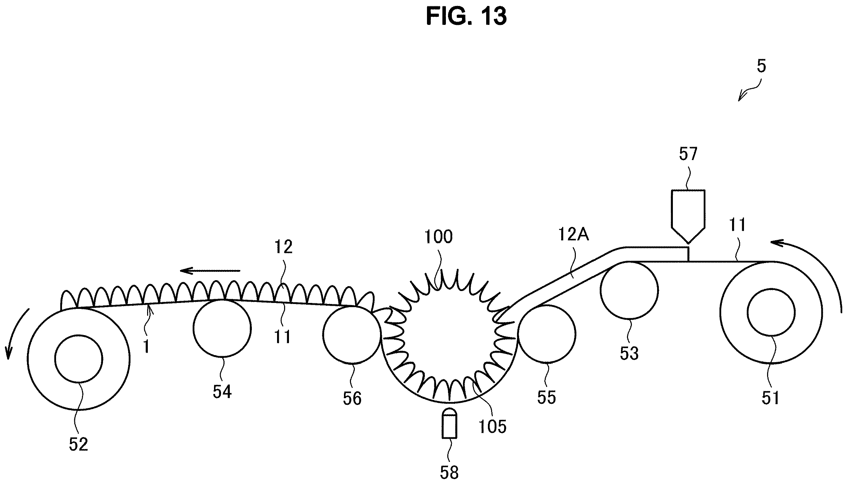

Next, a method for continuously transferring the transfer pattern from the roll master 100 to the optical film 1 by the roll-to-roll technique in the method for manufacturing the optical film 1 according to the present embodiment will be described with reference to FIG. 13. FIG. 13 is a schematic view showing a configuration of a transfer device 5 according to the present embodiment.

As shown in FIG. 13, the transfer device 5 includes the roll master 100, a base material supply roll 51, a take-up roll 52, guide rolls 53 and 54, a nip roll 55, a separation roll 56, a coating device 57, and the light source 58. That is, the transfer device 5 shown in FIG. 13 is an imprinting transfer device by the roll-to-roll technique.

The base material supply roll 51 is, for example, a roll obtained by winding the base material 11 of the optical film 1 into a roll shape. The take-up roll 52 is a roll for taking up the optical film 1 in which a concave-convex pattern 105 has been transferred to the resin layer 12. In addition, the guide rolls 53 and 54 are rolls for transporting the base material 11 before and after transfer. The nip roll 55 is a roll for pressing the base material 11 coated with the resin layer 12A yet to be cured against the outer peripheral surface of the roll master 100. The separation roll 56 is a roll for separating the base material 11 having laminated thereon the resin layer 12 to which the concave-convex pattern 105 has been transferred from the roll master 100.

The coating device 57 coats the base material 11 with a transfer material made of a curable resin composition yet to be cured, for example, to form the resin layer 12A yet to be cured on the base material 11. The coating device 57 may be a device such as a gravure coater, a wire bar coater, or a die coater, for example. In addition, the light source 58 is a light source that emits light of a wavelength at which the light curable resin composition can be cured, and is a device such as a UV lamp, for example.

Note that the curable resin composition may be a light curable resin to be cured by emission of light having a predetermined wavelength, for example. Specifically, the light curable resin composition may be a UV curable resin such as acrylic resin acrylate or epoxy acrylate. In addition, the light curable resin composition may contain an initiator, a filler, a functional additive, a solvent, an inorganic material, a colorant, an antistatic agent, a sensitizing dye, or the like according to necessity.

Note that the resin layer 12A yet to be cured may be formed of a thermal curable resin composition. In this case, the transfer device 5 may be provided with a heat source (for example, a heater) instead of the light source 58, and the resin layer 12A may be heated by the heat source to cure the resin layer 12A. The thermal curable resin composition may be phenolic resin, epoxy resin, melamine resin, urea resin, or the like, for example.

Next, the transfer method by the roll-to-roll technique through use of the transfer device 5 of the above-described configuration will be described.

First, the strip-shaped base material 11 wound around the base material supply roll 51 is unwound from the base material supply roll 51 and continuously delivered via the guide roll 53. Then, the surface of the base material 11 is continuously coated with the light curable resin composition (the transfer material) by the coating device 57, and the resin layer 12A yet to be cured is laminated on the base material 11. Further, the resin layer 12A laminated on the base material 11 is pressed against the outer peripheral surface of the roll master 100 by the nip roll 55. The concave-convex pattern 105 (for example, the aforementioned micro concave-convex structure 120 and the groove 131) formed on the outer peripheral surface of the roll master 100 is thereby continuously transferred to the resin layer 12A.

Then, the resin layer 12A to which the concave-convex pattern 105 has been transferred is cured by emission of light from the light source 58. A structure obtained by inverting the concave-convex pattern 105 (for example, the aforementioned micro concave-convex structure 20 and the ridge portions 31) is thereby formed on the resin layer 12. Thereafter, the optical film 1 composed of the resin layer 12 to which the concave-convex pattern 105 has been transferred and the base material 11 is separated from the roll master 100 by the separation roll 56. Thereafter, the optical film 1 is delivered to the take-up roll 52 via the guide roll 54 and taken up into a roll shape on the take-up roll 52.

As described above, the transfer device 5 according to the present embodiment enables the concave-convex pattern 105 formed on the outer peripheral surface of the roll master 100 to be continuously transferred by the roll-to-roll technique to manufacture the optical film 1. Consequently, the optical film 1 can be efficiently mass-produced.

In addition, in the case of transferring the transparent micro concave-convex structure 20 such as a moth-eye structure by the roll-to-roll technique, the surface of the transparent base material 11 is coated with a curable resin (the resin layer 12A yet to be cured) such as a transparent UV curable resin, and then the base material 11 is pressed against the outer peripheral surface of the roll master 100 being rotated. As a result, the curable resin spreads between the outer peripheral surface of the roll master 100 and the base material 11, so that a coated range with the curable resin is widened. On this occasion, it is difficult for an operator to view a range of the transparent base material 11 coated with the transparent curable resin (particularly, the coated range in the roll width direction). Thus, the coated range with the curable resin in the roll width direction cannot be controlled well, so that a failure such as flowing out of the curable resin from between the roll master 100 and the base material 11 or occurrence of incomplete coating of a partial region of the surface of the base material 11 with the curable resin is likely to occur. Hence, it is desirable that line markers which are easily visible should be present across the entire periphery of the roll master 100 at the ends in the roll width direction of the roll master 100.

In this respect, according to the present embodiment, the strip-shaped line marker regions 103 are provided across the entire periphery in the roll peripheral direction in the vicinity of both the ends in the roll width direction of the outer peripheral surface of the roll master 100, as shown in FIG. 5. Since the spiral grooves 131 that function as the diffraction grating are formed in these line marker regions 103, rainbow-colored diffusion light is output from the line marker regions 103 because of diffraction and interference of light. Consequently, the operator can easily view the line marker regions 103 provided at both the ends in the roll width direction of the roll master 100. Thus, the range coated with the transparent curable resin can be viewed and controlled using the positions of the visible line marker regions 103 as guides, so that the supplied amount of the curable resin to be coated and the like can be controlled to appropriately control the coated range with the curable resin. As a result, a failure such as flowing out of or incomplete coating with the curable resin can be prevented from occurring, which can improve the productivity and quality of the optical film 1.

### [7. Application Examples]

Next, various application examples of the optical film 1 according to the present embodiment will be described.

### [7.1. Improvement of Visibility of Film Product]

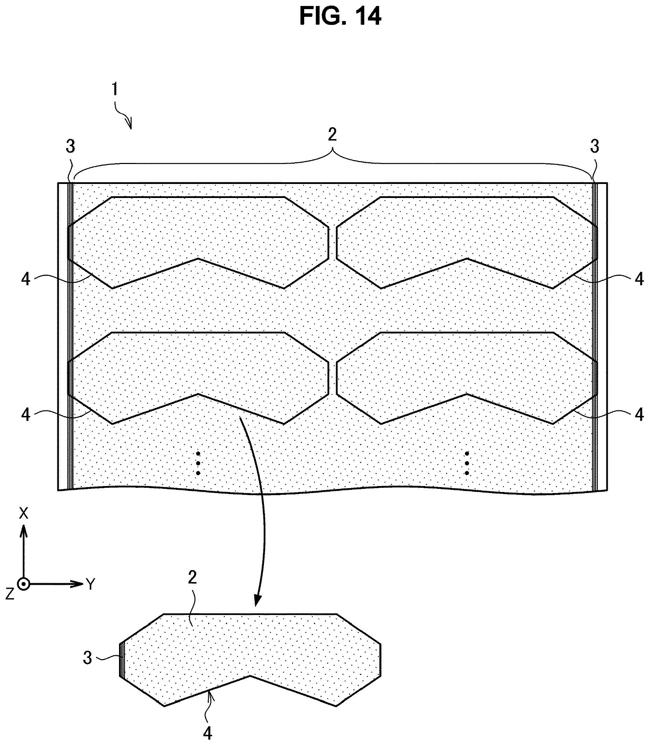

First, an example of performing punching processing of the optical film 1 according to the present embodiment to fashion a product of an antireflection film (for example, a shield member such as an eye shield or a face shield, or a product of another optical member) will be described with reference to FIG. 14. FIG. 14 is a plan view showing an example of performing punching processing of a plurality of eye shields 4 from the optical film 1 according to the present embodiment.

The optical film 1 according to the present embodiment may be stored as a film roll (see FIG. 1) obtained by winding a strip-shaped film into a roll shape, for example. In the case of manufacturing a shield member or a product (a sheet product) of another optical member from such a film roll, the strip-shaped optical film 1 unwound from the film roll is subjected to punching processing to fashion a film product having a predetermined shape. Note that the strip-shaped optical film 1 unwound from the film roll may be subjected to cutting processing to have a predetermined length before the punching processing.

In the case of performing the punching processing of the plurality of eye shields 4 from the optical film 1 as shown in FIG. 14, it is preferable to perform the punching processing of the eye shields 4 such that the line marker regions 3 at both the ends in the width direction of the optical film 1 are included at least partially in the respective eye shields 4. In the example of FIG. 14, the eye shields 4 are subjected to punching processing in two rows in the width direction (the Y direction) of the strip-shaped optical film 1 such that the line marker region 3 is included at one-side end of each of the eye shields 4.

As mentioned above, the line marker region 3 includes the cyclic structure of the plurality of ridge portions 31 that function as the diffraction grating. Since this line marker region 3 shines in rainbow colors, the user can easily view the line marker region 3. Consequently, even if most of the region of the sheet product of the eye shield 4 obtained by punching processing is a transparent region (the concave-convex pattern region 2) having the antireflection function, the sheet product of the eye shield 4 can be significantly improved in visibility because of the presence of the line marker region 3 as long as the line marker region 3 is partially included in the eye shield 4.

This enables the user to easily view the sheet product of the eye shield 4 which is mostly transparent using the line marker region 3 as a sign, and the handling properties of the sheet product of the eye shield 4 are improved. For example, when the user carries or puts on/off the sheet product of the eye shield 4, he/she can easily view and handle the eye shield 4. In addition, the user can easily find the sheet product of the eye shield 4 even if dropped on the floor.

In this manner, according to the present embodiment, user's handling properties of the product such as the eye shield 4 are significantly improved because the visible line marker region 3 is partially formed even in the case where a transparent region occupies the most part of the sheet product such as the eye shield 4 obtained by fashioning the optical film 1.

Note that although the example in which the line marker region 3 is included at one-side end of the eye shield 4 has been described with reference to FIG. 14, the present invention is not limited to such an example. As long as the line marker region 3 is partially present in a film product such as the eye shield 4, the position at which the line marker region 3 is present in the film product, orientation, range, number, and the like are not particularly limited.

### [7.2. Defect Management for Roll Master]

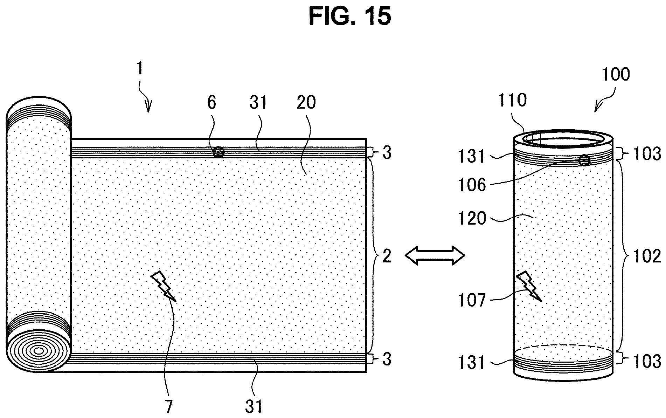

Next, a method for managing a defect 107 in the roll master 100 using a marker 106 representing the position of the roll peripheral direction of the roll master 100 will be described with reference to FIG. 15. FIG. 15 is an explanatory diagram showing a defect 7 on the optical film 1 according to the present embodiment, the defect 107 on the roll master 100, and markers 6 and 106.

As mentioned above, in the method for manufacturing the optical film 1 according to the present embodiment, the concave-convex pattern (the micro concave-convex structure 120 in the concave-convex pattern region 2) formed on the outer peripheral surface of the roll master 100 is continuously transferred to the resin layer 12 of the optical film 1 by the roll-to-roll technique. In this transfer step, the defect 107 may occur on the concave-convex pattern on the outer peripheral surface of the roll master 100 for some reason as shown in FIG. 15. When the defect 107 is transferred from the roll master 100 to the optical film 1, the defect 7 corresponding to the defect 107 also cyclically occurs on the surface of the optical film 1. This leads to degradation in performance and quality of the optical film 1 as well as reduction in yield.

Hence, defect management for the roll master 100 is important in the transfer method by the roll-to-roll technique in order to improve the productivity and quality of the optical film 1. Herein, in order to manage the defect 107 on the concave-convex pattern (the micro concave-convex structure 120 in the concave-convex pattern region 2) of the roll master 100, the marker 106 desirably is provided in a region other than the concave-convex pattern region 2 of the outer peripheral surface of the roll master 100. Further, in order to specify the position of the defect 107 on the roll master 100 from the position of the defect 7 (hereinafter referred to as the "cyclic defect 7") cyclically occurring on the optical film 1, it is preferable that the marker 106 should be stamped on the outer peripheral surface of the roll master 100 and this marker 106 should be transferred to the optical film 1.

Hence, in the present embodiment, the marker 106 is provided in the line marker region 103 of the roll master 100 as shown in FIG. 15. The marker 106 is identification information (a mark) representing the reference position of the roll peripheral direction of the roll master 100. Although the marker 106 in the example of FIG. 15 is composed of a circular mark stamped in the line marker region 103, the shape of the marker 106 is not limited as long as it serves as a mark representing the reference position of the roll peripheral direction.

By providing the marker 106 in the line marker region 103 of the roll master 100, the marker 6 having a shape obtained by inverting the marker 106 is cyclically transferred to the line marker region 3 of the optical film 1. The cycle (pitch) of the marker 6 in the longitudinal direction of the optical film 1 is the perimeter of the roll master 100.

In this manner, provided that the marker 6 is present in the line marker region 3 of the optical film 1, the position of the defect 107 (the position of the roll peripheral direction) on the outer peripheral surface of the roll master 100 can be easily specified based on a coordinate position of the cyclic defect 7 (the distance from the marker 6 to the defect 7) on the concave-convex pattern region 2 of the optical film 1. On this occasion, even if the defect 107 on the outer peripheral surface of the roll master 100 is minute and difficult to find to the naked eye, the position of the minute defect 107 on the outer peripheral surface of the roll master 100 can be specified if there is information about the coordinate position of the cyclic defect 7 on the optical film 1. If the position of the defect 107 on the roll master 100 can be specified, the defect 107 can be repaired to restore the quality of the optical film 1, so that the productivity can be improved with a defective product prevented from occurring.

As described above, in the case where the defect 7 having the cyclic property occurs on the optical film 1, the present embodiment enables the position of the defect 107 on the roll master 100 itself to be specified from the coordinate position of the defect 7 based on the marker 6, and a defect countermeasure against the defect 7 can be speedily executed. Thus, defect management and defect countermeasure can be effectively executed.

Alternatively, in contrast to the foregoing, the position of the cyclic defect 7 (the distance from the marker 6 to the defect 7) on the optical film 1 can also be specified from the coordinate position of the defect 107 (the position of the roll peripheral direction) on the outer peripheral surface of the roll master 100. If the position of the cyclic defect 7 on the optical film 1 is known, the position at which the optical film 1 is subjected to punching processing can be designated avoiding the position of the cyclic defect 7 to fashion a high-quality film product not including the cyclic defect 7.

### [7.3. Traceability Management with Open Characters]

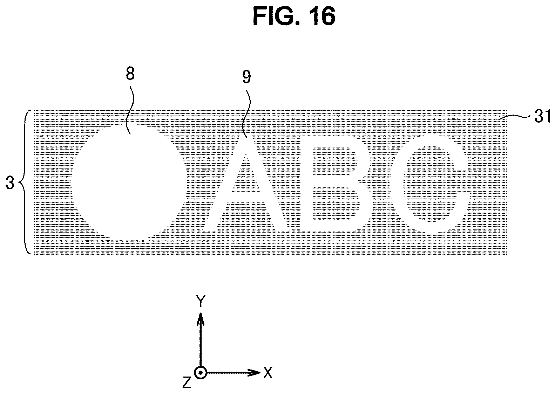

Next, an application example of displaying identification information such as a marker, a character, or a symbol in the line marker region 3 with open characters for utilization for traceability management for the optical film 1 will be described with reference to FIG. 16. FIG. 16 is a plan view showing a marker 8 and open characters 9 formed in the line marker region 3 of the optical film 1 according to the present embodiment.

As shown in FIG. 16, the marker 8 as a circle and the open characters 9 composed of alphabetical characters, for example, are formed in the line marker region 3 of the optical film 1. The marker 8 and the open characters 9 are displayed in a visible manner by portions (open portions) in which the ridge portions 31 are not formed in the line marker region 3.

In the line marker region 3 in the example of FIG. 16, the plurality of ridge portions 31 are intermittently formed in the longitudinal direction of the line marker region 3. The portions in which the ridge portions 31 are formed function as the aforementioned diffraction grating to become a visible region that shines in rainbow colors. On the other hand, the portions in which the ridge portions 31 are not formed neither function as the diffraction grating nor shine in rainbow colors, but are displayed as open characters by contrast with the surrounding region that shines in rainbow colors (the portions in which the ridge portions 31 are formed). In this manner, identification information such as the marker 8, the open characters 9, and any other symbol can be displayed in a visible manner in the line marker region 3 depending on whether or not the ridge portions 31 are formed.

In this manner, in order to display the marker 8, the open characters 9, and the like in the line marker region 3 of the optical film 1 by a pattern depending on whether or not the ridge portions 31 are formed, a transfer pattern corresponding to the pattern needs to be formed in the line marker region 103 of the roll master 100. Thus, by intermittently forming the above-described spiral groove 131 also in the line marker region 103 of the roll master 100, identification information such as the above-described marker 8 and the open characters 9 is displayed by portions (open portions) in which the groove 131 is not formed.

Hence, in the exposure step (S12) of the method for manufacturing the aforementioned roll master 100, on/off of emission of laser light is controlled in conformity with the pattern of identification information such as the marker 8 and the open characters 9 to form an exposure pattern corresponding to the identification information on the resist layer 111 of the master base material 110. A transfer pattern representing the identification information such as the marker 8 and the open characters 9 can thereby be formed in the line marker region 103 of the roll master 100 depending on whether or not the groove 131 is formed. Then, the transfer pattern representing the identification information is transferred from the line marker region 103 of the roll master 100 to the line marker region 3 of the optical film 1. The identification information such as the marker 8 and the open characters 9 shown in FIG. 16 can thereby be displayed in the line marker region 3 of the optical film 1.

As described above, according to the present embodiment, the identification information including the marker 8, the open characters 9, another symbol, and the like is displayed in the line marker region 3 of the optical film 1. Various types of identification information concerning the optical film 1, the roll master 100, and the like can thereby be provided.

For example, the circular marker 8 shown in FIG. 16 can be utilized as a mark representing the reference position of the roll peripheral direction of the roll master 100 used for manufacturing the optical film 1. By displaying the marker 8 representing the reference position of the roll peripheral direction of the roll master 100, the defect management and defect countermeasure for the roll master 100 and the optical film 1 can be suitably executed as described above with reference to FIG. 15.

In addition, the alphabetical open characters 9 shown in FIG. 16 may be characters or symbols representing a lot number when the optical film 1 is manufactured, for example. By displaying the lot number with the open characters 9, identification information for specifying a manufacturing lot of the optical film 1 and the roll master 100 used for manufacturing the optical film 1 can be provided for an operator.

Consequently, in the case where the defect 7 occurs on the optical film 1, the manufacturing lot of the optical film 1 and the roll master 100 can be specified. Thus, these types of identification information enable highly reliable traceability management and defect management to be easily and suitably achieved.

Further, the line marker regions 103 of the roll master 100 and the line marker region 3 of the optical film 1 are long as a strip shape, so that identification information having a long number of characters such as a lot number can be stamped/displayed in the line marker regions 103 and 3 by open characters. This enables detailed identification information to be displayed, which can achieve more detailed traceability management.

### [8. Conclusion]

The optical film 1 according to the present embodiment and the method for manufacturing the same, as well as the roll master 100 to be used for the manufacturing method and the like have been described above in detail.

In the optical film 1 according to the present embodiment, the strip-shaped line marker regions 3 extending in the film longitudinal direction are provided at both the ends in the film width direction. Then, the plurality of ridge portions 31 are formed in the line marker regions 3. The plurality of ridge portions 31 are arrayed at intervals from one another at the micrometer-size track pitch Pt more than or equal to the wavelength of visible light. The plurality of ridge portions 31 in the line marker regions 3 thereby function as the diffraction grating, so that light incident on the line marker regions 3 diffracts and interferes because of the ridge portions 31 to be divided per wavelength. As a result, rainbow-colored diffusion light is output from the line marker regions 3, so that the line marker regions 3 become visible regions. The line marker regions 3 that shine in rainbow colors are higher in visibility to the naked eye than the transparent concave-convex pattern region 2.

Consequently, a user of an optical film product (such as an eye shield or a face shield, for example) obtained by using the optical film 1 can easily view the line marker regions 3 that shine in rainbow colors even in a case where the transparent concave-convex pattern region 2 of the optical film 1 is difficult to view. Thus, visibility when the user handles the transparent optical film product can be improved.

In addition, when handling the optical film 1 which is a transferred object in a production step, an operator can view the line marker regions 3 of the transparent optical film 1 that shine in rainbow colors. Thus, operability is improved. Further, since the line marker regions 103 are also formed in the transparent roll master 100, visibility of the transparent roll master 100 is also improved and operability when handling the roll master 100 can also be improved by similar principles.

Further, in the method for manufacturing the optical film 1 according to the present embodiment, the transfer pattern of the concave-convex pattern region 102 and the line marker regions 103 formed on the outer peripheral surface of the roll master 100 are transferred at the same time to the surface of the resin layer 12A on the base material 11 of the film in the transfer step (S24) shown in FIG. 11, thereby manufacturing the optical film 1. This enables the concave-convex pattern region 2 (the antireflection region) and the line marker regions 3 (the visible regions) to be easily formed on the surface of the optical film 1 in the identical processing step. Further, both the micro concave-convex structure 20 in the concave-convex pattern region 2 and the ridge portions 31 in the line marker regions 3 can be integrally formed on the identical resin layer 12 laminated on the surface of the base material 11 of the optical film 1. Thus, the optical film 1 can be efficiently mass-produced.

In addition, in a case of manufacturing the line marker regions 3 of the optical film 1 in an additional step (such as another imprinting step, for example) other than the transfer step for forming the concave-convex pattern region 2, the additional step may cause a new defect in the concave-convex pattern region 2. However, in the method for manufacturing the optical film 1 according to the present embodiment, the concave-convex pattern region 2 and the line marker regions 3 are integrally formed at the same time in the identical step, which eliminates the need for adding a step and does not result in occurrence of a new defect.

In addition, according to the present embodiment, the line marker regions 103, 103 which are highly visible are present across the entire periphery of the roll master 100 at both the ends in the roll width direction of the roll master 100. Thus, when coating the transparent base material 11 pressed against the outer peripheral surface of the roll master 100 with a transfer material such as a transparent curable resin in the transfer step (S24) by the roll-to-roll technique, its coating width can be suitably controlled using the line marker regions 103, 103 at both the ends in the roll width direction as references.

In addition, according to the present embodiment, the strip-shaped optical film 1 is manufactured using the roll master 100 in which the line marker regions 103 are present across the entire periphery. The line marker regions 3 which are highly visible are thereby formed in a strip shape across the entire strip-shaped optical film 1 in the longitudinal direction. Thus, when the punching processing of an optical film product such as the eye shield 4 from the strip-shaped optical film 1 is performed as shown in FIG. 14, the line marker region 3 which is highly visible can be included in the optical film product in addition to the transparent concave-convex pattern region 2. This can improve the visibility of the optical film product such as the eye shield 4, so that the handling properties of the optical film product can also be improved.

In addition, according to the present embodiment, when the defect 7 having the cyclic property occurs on the optical film 1 as shown in FIG. 15, the coordinate position of the defect 7 can be specified using the marker 6 transferred to the line marker regions 3 as a reference. Since the position of the defect 107 on the roll master 100 itself from which the optical film 1 has been manufactured can thereby be specified, the countermeasure against the defect 107 can be promptly executed. Consequently, defect management for the roll master 100 can be carried out with high accuracy, and the optical film 1 manufactured from the roll master 100 can be improved in productivity and quality.

In addition, according to the present embodiment, identification information (for example, a character string such as a lot number) concerning manufacturing of the optical film 1 and the roll master 100 can be displayed in the line marker regions 3 of the optical film 1 with the marker 8, the open characters 9, and the like as shown in FIG. 16. This enables traceability management and defect management for the optical film 1 to be carried out with high accuracy and easily.

In addition, in the method for manufacturing the roll master 100 according to the present embodiment, the concave-convex pattern region 102 and the line marker region 103 are etched at the same time. The depth H' of the concavities 121 in the concave-convex pattern region 102 and the depth h' of the spiral groove 131 in the line marker region 103 thereby become substantially identical on the outer peripheral surface of the roll master 100. As a result, the height H of the convexities 21 in the concave-convex pattern region 2 and the height h of the ridge portions 31 in the line marker region 3 also become substantially identical on the surface of the optical film 1 to which the concave-convex pattern of the roll master 100 has been transferred. Thus, when the optical film 1 is wound into a film roll shape, a failure such as rolling distortion is unlikely to occur.

An embodiment of the present invention has been described above with reference to the accompanying drawings, whilst it goes without saying that the present invention is not limited to the embodiment. A person skilled in the art may obviously find various alterations and modifications within the scope of the appended claims, and it should be understood that they will naturally come under the technical scope of the present invention.

### Reference Signs List

- 1: optical film
- 2: concave-convex pattern region
- 3: line marker region
- 4: eye shield
- 5: transfer device
- 6: marker
- 7: defect
- 8: marker
- 9: open character
- 11: base material
- 12: resin layer
- 12A: resin layer yet to be cured
- 20: micro concave-convex structure
- 21: convexity
- 22: concavity
- 31: ridge portion
- 32: flat portion
- 100: roll master
- 102: concave-convex pattern region
- 103: line marker region
- 110: master base material
- 111: resist layer
- 112: latent image
- 113A, 113B: opening
- 120: micro concave-convex structure
- 121: concavity
- 122: convexity
- 131: spiral groove
- 200: exposure device
- 201: laser light source
- 202: laser light

## Claims

1. An optical film comprising:
a base material having flexibility; and
a resin layer laminated on at least one of surfaces of the base material, wherein
the resin layer includes
a concave-convex pattern region in which a micro concave-convex structure composed of a plurality of convexities or concavities arrayed at a pitch less than or equal to a wavelength of visible light is formed, and
a strip-shaped line marker region in which a plurality of ridge portions arrayed at intervals from one another at a track pitch more than or equal to the wavelength of visible light are formed.

2. The optical film according to claim 1, wherein each of the ridge portions has a linear shape extending in a longitudinal direction of the line marker region, and the plurality of ridge portions are arrayed in parallel to one another.

3. The optical film according to claim 1 or 2, wherein visible light divided per wavelength is output from the line marker region by diffraction and interference of light incident on the line marker region because of a cyclic structure of the ridge portions arrayed in the line marker region.

4. The optical film according to any one of claims 1 to 3, wherein
the concave-convex pattern region is a transparent region provided with an antireflection function by the micro concave-convex structure, and
the line marker region is a visible region that functions as a diffraction grating because of a cyclic structure of the ridge portions.

5. The optical film according to any one of claims 1 to 4, wherein the track pitch of the ridge portions is more than or equal to 500 nm and less than or equal to 1 mm.

6. The optical film according to any one of claims 1 to 5, wherein the track pitch of the ridge portions is more than or equal to 1 µm and less than or equal to 10 µm.

7. The optical film according to any one of claims 1 to 6, wherein a height of the ridge portions is substantially identical to a height of the convexities of the micro concave-convex structure.

8. The optical film according to any one of claims 1 to 7, wherein the ridge portions are intermittently formed in the line marker region, and identification information including at least any of a character, a symbol, or a marker is displayed in a visible manner by portions in which the ridge portions are not formed.

9. The optical film according to claim 8, wherein the identification information includes a marker representing a reference position of a peripheral direction of a roll master used for manufacturing the optical film.

10. The optical film according to claim 8, wherein the identification information includes a character or a symbol representing a lot number when the optical film is manufactured.

11. The optical film according to any one of claims 1 to 10, wherein the optical film is a film roll obtained by winding an elongated film.

12. The optical film according to any one of claims 1 to 10, wherein the optical film is a sheet product of a film having a predetermined shape.

13. A method for manufacturing the optical film according to any one of claims 1 to 12 using a roll master, the method comprising:
preparing the roll master including a master concave-convex pattern region and a master line marker region on an outer peripheral surface of the roll master, a master micro concave-convex structure having a shape obtained by inverting the micro concave-convex structure in the concave-convex pattern region of the optical film being formed in the master concave-convex pattern region, the master line marker region being provided in a strip shape across an entire periphery of the roll master, and a spiral groove having a shape obtained by inverting the ridge portions in the line marker region of the optical film being formed in the master line marker region;
coating a surface of the base material of the optical film with a resin layer made of a curable resin; and
transferring a transfer pattern including the master micro concave-convex structure formed in the master concave-convex pattern region of the roll master and the groove formed in the master line marker region to the resin layer to integrally form the micro concave-convex structure in the concave-convex pattern region of the optical film and the ridge portions in the line marker region of the optical film in the resin layer.
